(19) **Europäisches Patentamt**
**European Patent Office**
**Office européen des brevets**

(11) **EP 1 668 780 B1**

(12) **EUROPEAN PATENT SPECIFICATION**

(45) Date of publication and mention
of the grant of the patent:
**12.12.2007 Bulletin 2007/50**

(51) Int Cl.:
***H03M 7/30*** *(2006.01)*

(21) Application number: **05770595.6**

(86) International application number:
**PCT/JP2005/014870**

(22) Date of filing: **08.08.2005**

(87) International publication number:
**WO 2006/022156 (02.03.2006 Gazette 2006/09)**

(54) **METHOD FOR COMPRESSING A SET OF CORRELATED SIGNALS**

VERFAHREN ZUM KOMPRIMIEREN EINER MENGE KORRELIERTER SIGNALE

PROCEDE DE COMPRESSION D'UN ENSEMBLE DE SIGNAUX CORRELES

(84) Designated Contracting States:
**DE FR GB**

(30) Priority: **27.08.2004 US 928448**

(43) Date of publication of application:
**14.06.2006 Bulletin 2006/24**

(73) Proprietor: **MITSUBISHI DENKI KABUSHIKI KAISHA**
**Chiyoda-ku, Tokyo 100-8310 (JP)**

(72) Inventors:
• **YEDIDIA, Jonathan, S.**
**Cambridge, MA 02139 (US)**
• **VETRO, Anthony**
**NY 10314 (US)**
• **KHISTI, Ashish**
**Toronto**
**Ontario M1B5P1 (CA)**
• **MALIOUTOV, Dmitry**
**Brookline, MA 02467 (US)**

(74) Representative: **Pfenning, Meinig & Partner GbR**
**Patent- und Rechtsanwälte**
**Theresienhöhe 13**
**80339 München (DE)**

(56) References cited:
• **CHEN J ET AL: "Distributed source coding using serially-concatenated-accumulate codes" 2004 IEEE INFORMATION THEORY WORKSHOP (IEEE CAT. NO.04EX944) IEEE PISCATAWAY, NJ, USA, 2004, pages 209-214, XP002346285 ISBN: 0-7803-8720-1**
• **MAJUMDAR A ET AL INSTITUTE OF ELECTRICAL AND ELECTRONICS ENGINEERS: "Robust distributed video compression based on multilevel coset codes" CONFERENCE RECORD OF THE 37TH. ASILOMAR CONFERENCE ON SIGNALS, SYSTEMS, & COMPUTERS. PACIFIC GROOVE, CA, NOV. 9 - 12, 2003, ASILOMAR CONFERENCE ON SIGNALS, SYSTEMS AND COMPUTERS, NEW YORK, NY : IEEE, US, vol. VOL. 1 OF 2. CONF. 37, 9 November 2003 (2003-11-09), pages 845-849, XP010701850 ISBN: 0-7803-8104-1**
• **QIAN XU ET AL: "Layered Wyner-Ziv video coding" PROCEEDINGS OF THE SPIE - THE INTERNATIONAL SOCIETY FOR OPTICAL ENGINEERING SPIE-INT. SOC. OPT. ENG USA, vol. 5308, no. 1, 10 February 2004 (2004-02-10), pages 83-91, XP002346286 ISSN: 0277-786X**
• **DESLAURIERS I ET AL: "On modeling and turbo compression of grayscale images in the Slepian-Wolf context" ELECTRICAL AND COMPUTER ENGINEERING, 2004. CANADIAN CONFERENCE ON NIAGARA FALLS, ONT., CANADA 2-5 MAY 2004, PISCATAWAY, NJ, USA,IEEE, US, 2 May 2004 (2004-05-02), pages 2297-2302Vol4, XP010733898 ISBN: 0-7803-8253-6**
• **SEHGAL A ET AL: "A state-free causal video encoding paradigm" PROCEEDINGS 2003 INTERNATIONAL CONFERENCE ON IMAGE PROCESSING. ICIP-2003. BARCELONA, SPAIN, SEPT. 14 - 17, 2003, INTERNATIONAL CONFERENCE ON IMAGE PROCESSING, NEW YORK, NY : IEEE, US, vol. VOL. 2 OF 3, 14 September 2003 (2003-09-14), pages 605-608, XP010670186 ISBN: 0-7803-7750-8**

**(Cont. next page)**

- **LIVERIS A D ET AL: "Joint source-channel coding of binary sources with side information at the decoder using IRA codes" PROCEEDINGS OF THE 2003 IEEE RADAR CONFERENCE. HUNTSVILLE, AL, MAY 5 - 8, 2003, IEEE RADAR CONFERENCE, NEW YORK, NY : IEEE, US, 9 December 2002 (2002-12-09), pages 53-56, XP010642512 ISBN: 0-7803-7920-9**

**Description**

**Technical Field**

The present invention relates generally to the field of compressing signals, and more particularly to the compressing of correlated signals using error-correcting channel codes.

**Background Art**

A fundamental problem in the field of data storage and signal communication is the development of practical methods to compress input signals, and then to reproduce the compressed signals without distortion or with a minimal amount of distortion. It should be understood that the signals as described herein can be in the form of digital data.

Methods for compressing and reproducing signals are very important parts in systems that store or transfer large amounts of data, as commonly arise with audio, image, or video files.

In many cases of interest, the signals that need to be compressed are correlated, but the generation of the signals is distributed in some way. For example, the signals are acquired by sensors that do not communicate with each other, for whatever reason. This means that the signals cannot be encoded using a single encoder. For example, the signals to be encoded are images of a scene acquired by different cameras, and it is desired to send an encoded version of the images from all of the cameras to a single central processor, without the cameras communicating directly with each other.

D. Slepian and J.K. Wolf describe this type of situation, which is often called "distributed source coding," in their landmark paper, see D. Slepian and J.K. Wolf, "Noiseless Coding of Correlated Information Sources," IEEE Transactions on Information Theory, vol. 19, pp. 471-480, 1973. They proved the surprising result that can be stated informally as "one does not lose any compression capability by not allowing the encoders to communicate." In other words, the compression that can be achieved if two encoders of correlated signals do not communicate is exactly the same as the compression that can be achieved if the two encoders do communicate with each other.

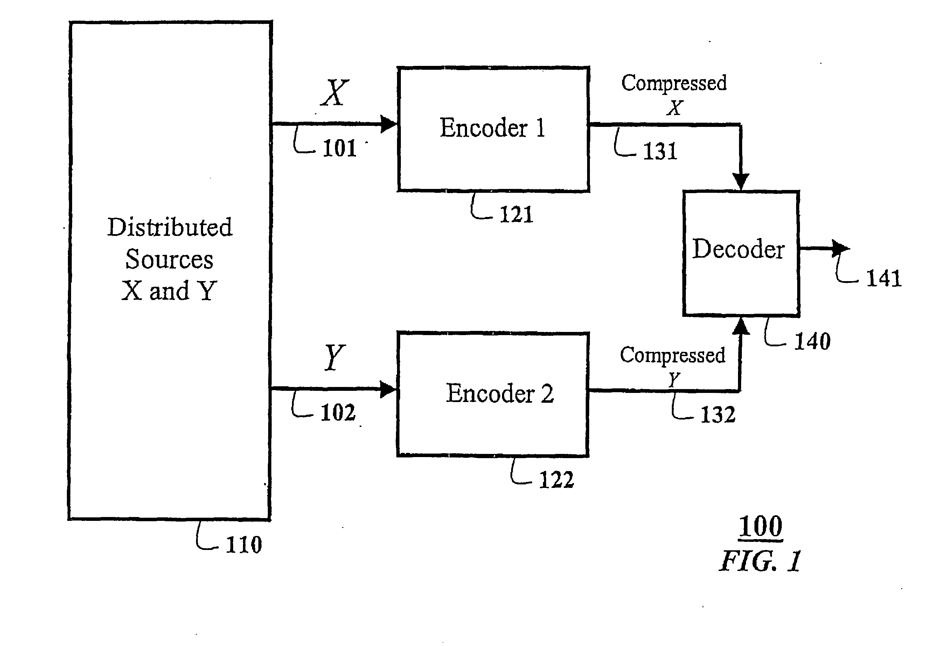

Figure 1 shows a block diagram of a prior art Slepian-Wolf coding system 100. Correlated output signals $X$ 101 and $Y$ 102 of distributed signal sources 110 are separately sent to two encoders 121-122, which do not communicate with each other. The first encoder generates a compressed signal stream $X$ 131, and the second encoder 122 generates a compressed signal stream $Y$ 132. The compressed signals 131-132 are sent to a decoder 140, which attempts to reconstruct the signals $X$ and $Y$ 141.

The encoding of correlated signals by encoders that do not communicate with each other is called "Slepian-Wolf compression." In their work, Slepian and Wolf focused on compression bounds set by information theory. They do not describe any practical method for implementing Slepian-Wolf compression encoders and decoders.

A. Wyner was probably the first to point out the idea that Slepian-Wolf compression could theoretically be implemented by having an encoder send "syndromes" of an error-correcting channel code, A.D. Wyner, "Recent Results in the Shannon Theory," IEEE Transactions on Information Theory, vol. 20, pp. 2-10, 1974. However, he did not provide any constructive details for practical methods for encoding and decoding.

Between 1974 and the end of the twentieth century, no real progress was made in devising practical Slepian-Wolf compression systems. For example, Sergio Verdu, in his 1998 review of fifty years of information theory, pointed out that "despite the existence of potential applications, the conceptual importance of Slepian-Wolf coding has not been mirrored in practical data compression, S. Verdu, 'Fifty years of Shannon Theory,' IEEE Transactions on Information Theory, vol. 44, pp. 2057-2078, 1998. Not much progress on constructive Slepian-Wolf schemes has been achieved beyond the connection with error-correcting channel codes revealed [by Wyner]."

Slepian and Wolf focused on the theory of compressing distributed correlated signals in a way such that the signals can later be recovered perfectly. Their theory was extended to lossy compression of distributed correlated sources by A. Wyner and J. Ziv, see A.D. Wyner and J. Ziv, "The rate-distortion function for source coding with side information at the decoder," IEEE Transactions on Information Theory, vol. 22, pp. 1-10, 1976. However, like Slepian and Wolf, Wyner and Ziv also do not describe any constructive methods to reach the bounds that they proved.

In "lossy compression," the reconstruction of the compressed signals does not perfectly match the original signals. Instead, the reconstructed signal only matches the original signal to a certain distortion level. Because lossy compression does not aim to perfectly reconstruct the signals, lossy compression can achieve better compression rates than lossless compression. Lossy Slepian-Wolf compression is referred to as "Wyner-Ziv compression."

During the last several years, some constructive methods for Slepian-Wolf and Wyner-Ziv compression, based on using syndromes from error-correcting channel codes, have been described.

**Entropy**

Performance measures for the Slepian-Wolf compression systems are based on an entropy of the signals or data to be compressed. The notion of the "entropy" dates back to Shannon's original paper introducing information theory, see C.E. Shannon, "A Mathematical Theory of Communication," Bell Sys. Tech. Journal, vol. 27, pp. 379-423, 1948. That material is covered in detail in textbooks on information theory, see for example, chapter 2 of T.M. Cover and J.A. Thomas, "Elements of Information Theory," 1990.

If $X$ is a discrete random variable selected from some alphabet $A_X$ with a probability distribution $p_X(x) =\Pr\{X = x\}$, then, the entropy $H(X)$ of the random variable $X$ is defined by

$$H(X) = -\sum_{x \in A_x} p_X(x) \log_2 p_X(x).  \qquad (1)$$

Shannon proved, in his famous coding theorem from his 1948 paper, that long sequences of $N$ symbols emitted by data $X$ can be compressed to a bit-stream having a rate of no less than $H(X)$ bits per symbol, and then recovered without loss. Thus, the entropy of a signal is the fundamental measure of its compressibility.

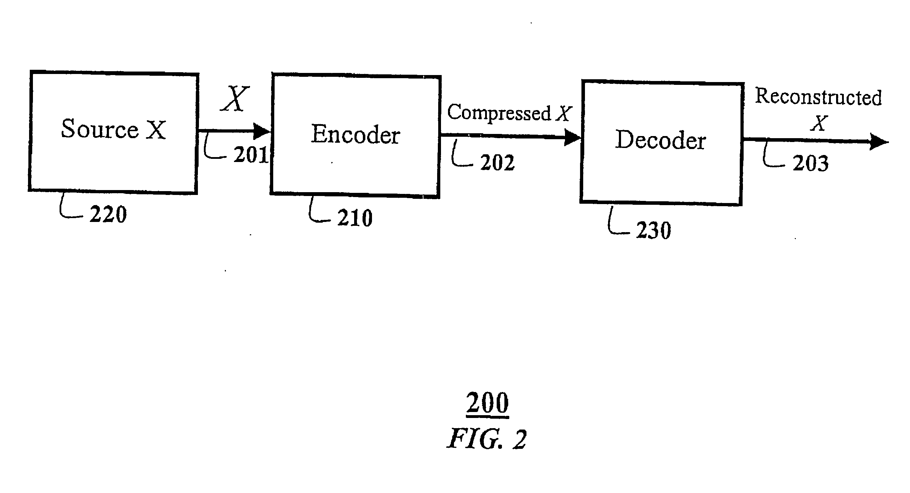

Figure 2 shows a conventional coding system 200. An encoder 210 compresses a signal $X$ of $N$ symbols 201 from a source X 220 to a compressed bit-stream $X$ 202 of no less than $NH(X)$ bits, which is then used by a decoder 230 to generate a reconstructed signal $X$ 203.

Now, assume that there are exactly two correlated sources X and Y, and that the signals produced by the sources X and Y are correlated random variables $X$ and $Y$. Assume that the random variables are selected according to a joint probability distribution $p_{XY}(x,y)=\Pr(X=x, Y=y)$. The following definitions are useful.

The *marginal probability distributions* $p_X(x)$ and $p_Y(y)$ are defined by

$$p_X(x) = \sum_y p_{XY}(x, y) \text{ and } p_Y(y) = \sum_x p_{XY}(x, y).$$

The *conditional probability distribution* $p_X(x|y)$ is defined by

$$p_X(x \mid y) = p_{XY}(x, y) / p_Y(y).$$

The *joint entropy* of the pair of random variables $(X, Y)$ is defined to be

$$H(X, Y) = -\sum_x \sum_y p_{XY}(x, y) \log_2 p_{XY}(x, y), \text{ and}  \qquad (2)$$

the *conditional entropy* $H(X|Y)$ is defined to be

$$H(X \mid Y) = -\sum_x \sum_y p_{XY}(x, y) \log_2 p_X(x \mid y).  \qquad (3)$$

The joint entropy $H(X,Y)$ and the conditional entropy $H(X|Y)$ are related by the equation $H(X,Y) = H(Y) + H(X|Y)$.

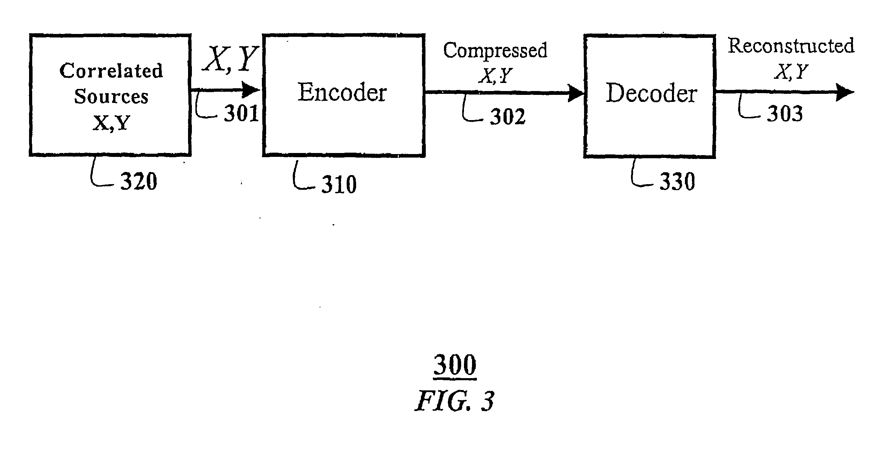

According to the Shannon's source coding theorem, a coding system 300 such as that shown in Figure 3 can successfully compress 310 $N$ pairs of signals $(X, Y)$ 301 from correlated sources X and Y 320 to a compressed bit-stream 302 of no less than $NH(X,Y)$, bits, and then recover 330 reconstructed signals $X$ and $Y$ 303, so long as $N$ is large. The encoder 310 in the compression system shown in Figure 3 has access to the outputs of both sources X and Y, i.e., the sources are not distributed.

Slepian and Wolf showed that a coding system such as that shown in Figure 1, where the two encoders have access to the symbols $X$ and $Y$ separately, and cannot communicate with each other, can still recover the original $N$ pairs of signals $(X, Y)$, assuming that $N$ is large, so long as the encoder having access to the source X sends at least

$NH(X|Y)$ bits, the encoder having access to the source Y sends at least $NH(Y|X)$ bits, and the total number of bits sent is at least $NH(X,Y)$.

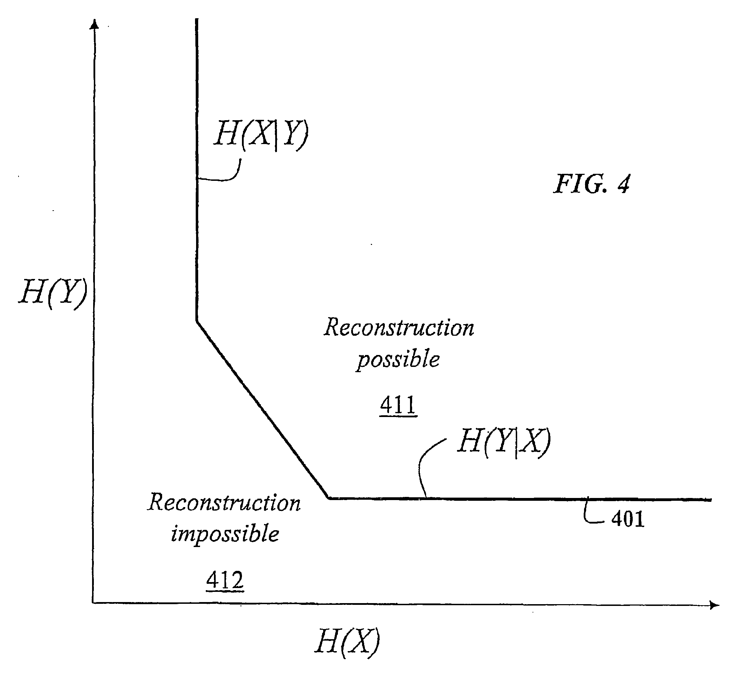

Figure 4 summarizes the Slepian-Wolf theorem, with the vertical axis showing the bits sent by source Y and the horizontal axis showing the bits sent by source X. The contour 401 shows the minimum number of bits that must be sent by the two encoders for successful reproduction at the decoder to be possible. The contour partitions the graph into a region 411 where reconstruction is possible, and an area 412 were reconstruction is impossible.

**Other Applications of Syndrome-Based Compression Methods**

There are other applications of syndrome-based compression methods besides the application described above for compressing correlated signals from distributed sources. In particular, syndrome-based compression methods shift much of the computational burden of compression from the encoder to the decoder, and are thus appropriate in cases where it is desired to encode in a very simple transmitter and receiver. For example, when the transmitting devices are cellular telephones or sensors with digital cameras, it is important that they consume little power when transmitting, and therefore simple encoders are desired.

Syndrome-based coding methods have therefore been proposed for use with video compression methods that have relatively simple encoders, see for example Puri and Ramchandran, "PRISM: A New Robust Video Coding Architecture Based on Distributed Compression Principles," Proc. 40th Allerton Conference on Communication, Control and Computing, October 2002, and A. Aaron, et al., "Towards practical Wyner-Ziv coding of video," Proc. IEEE International Conference on Image Processing, September 2003. The disadvantages of those encoders are detailed in the related Patent Application.

**Linear Block Error-Correcting Codes**

As previously mentioned, Wyner first pointed out in 1974 that Slepian-Wolf compression could be done by transmitting the syndromes of a linear block error-correcting code. The following provides the relevant background information about such linear block error-correcting codes. More information about error-correcting codes can be found in many textbooks, for example, the material discussed here is described in more detail in the first four chapters of the textbook by S. Lin and D.J. Costello, Jr., "Error Control Coding, 2nd Edition," Pearson Prentice Hall, 2004.

Any references to "codes" herein specifically mean *linear block error-correcting codes.* The basic idea behind these codes is to encode a string of $k$ symbols using a string of $N$ symbols, where $N > k$. In the conventional application of error-correcting codes, the additional $N - k$ bits are used to decode and correct corrupted encoded messages.

An arbitrary string of $N$ symbols is sometimes called a "block" or a "word." A block of $N$ symbols that satisfies all the constraints of the code is called a "code word." The symbols are drawn from a $q$-ary alphabet. A very important special case is when $q = 2$. In that case, the code is a "binary" code.

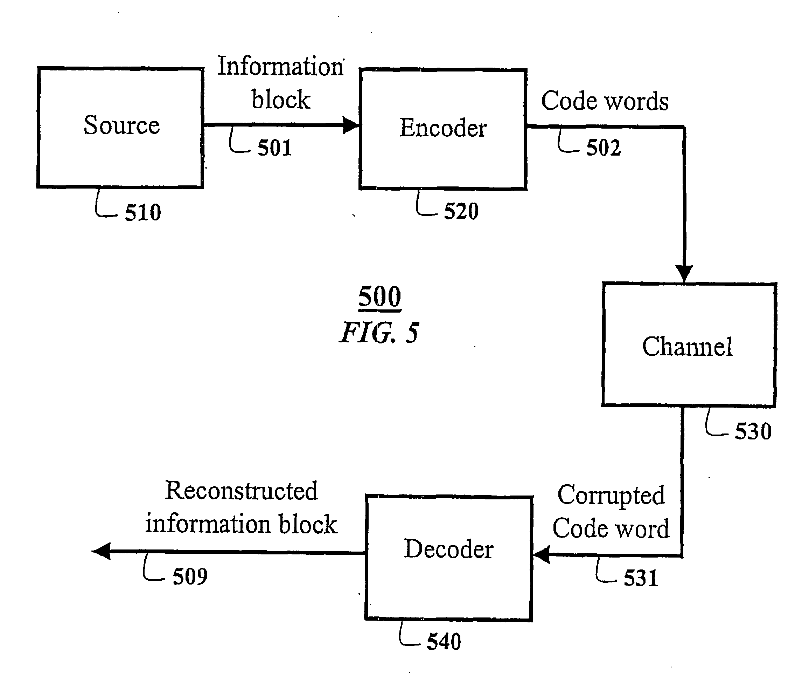

Figure 5 shows a conventional channel coder 500 that uses a linear block error-correcting code. A source 510 produces an information block 501 of $k$ symbols $u[a]$, where the symbols are drawn from a $q$-ary alphabet. The information block is passed to an encoder 520 of the error-correcting code, and are transformed into code words $x[n]$ 502 of $N$ symbols.

The code words are then transmitted through a channel 530, where the code words are corrupted into a signal $y[n]$ 531. The corrupted signal $y[n]$ is then passed to a decoder 540, which outputs a reconstruction 509 of the information block $u[a]$ 501, assuming the noise in the channel is relatively small.

**Parameters of Codes**

A code $C$ is defined by a set of $q^k$ possible code words having a block length $N$. The parameter $k$ is sometimes called the "dimension" of the code. Codes are normally much more effective when $N$ and $k$ are large. However, as the size of the parameters $N$ and $k$ increases, the complexity of a decoder for the code normally increases as well. The "rate" $R$ of the code is defined by $R = k/N$.

The Hamming distance between two code words is defined as the number of symbols that differ in the two code words. The distance $d$ of a code is defined as the minimum Hamming distance between all pairs of code words in the code. Codes with a larger value of $d$ have a greater error-correcting capability. Codes with parameters $N, k,$ and $q$ are referred to as $[N,k]_q$ codes. If the distance $d$ is also known, then they are referred to as $[N,k,d]_q$ codes.

**Galois Fields**

Linear codes can be represented by parity check matrices. To define these matrices, one first needs a way to add and multiply $q$-ary symbols. The theory of finite fields, which are also called Galois fields, provides a way to define addition and multiplication over $q$-ary symbols. See chapter 2 of the previously referenced textbook by S. Lin and D.

Costello for a detailed explanation of Galois fields.

In a Galois field, when any two symbols from a $q$-ary alphabet are added or multiplied together, the answer is an element from the same alphabet. There is a multiplicative and additive identity element, and each element has a multiplicative and additive inverse, except that the additive identity element has no multiplicative inverse.

Galois fields are denoted GF($q$), where $q$ is the number of elements in the alphabet. A Galois field can be defined in terms of its addition and multiplication tables. The simplest Galois field is GF(2), which has two elements 0 and 1, where 0 is the additive identity and 1 is the multiplicative identity. The addition rules for GF(2) are 0 + 0 = 1 + 1 = 0, and 0 + 1 = 1 + 0=1, and the multiplication rules for GF(2) are 0 * 0=0 * 1=1 * 0=0, and 1 * 1=1.

Galois fields can be defined for any $q$ that is a prime number or an integer power of a prime number. The addition and multiplication rules for any Galois field are described in textbooks on error-correcting codes. Unless stated otherwise, all sums and multiplications mentioned herein should be assumed to be sums and multiplications of binary symbols using the rules of GF(2).

**Parity Check Matrix Representations of Codes**

A block code is "linear" when the sum of any two code words is also a code word. The sum of two code words of $N$ symbols each is defined to be the code word of $N$ symbols, obtained by summing the individual symbols one at a time. For example the sum of the two code words (1110100) and (0111010) using GF(2) is (1001110).

Linear codes can be represented by parity check matrices. The parity check matrix representing an $[N, k]_q$ code is defined by a matrix of $q$-ary symbols, with $M$ rows and $N$ columns. The $N$ columns of the parity check matrix correspond to the $N$ symbols of the code. The number of linearly independent rows in the matrix is $N-k$.

Each row of the parity check matrix represents a constraint. The symbols involved in the constraint represented by a particular row correspond to the columns that have a non-zero symbol in that row. The parity check constraint forces the weighted sum, over GF($q$), of those symbols to be equal to zero. For example, for a binary code, the parity check matrix

$$H = \begin{bmatrix} 1 & 1 & 1 & 0 & 1 & 0 & 0 \\ 0 & 1 & 1 & 1 & 0 & 1 & 0 \\ 0 & 0 & 1 & 1 & 1 & 0 & 1 \end{bmatrix} \tag{4}$$

represents the three constraints

$$x[1] + x[2] + x[3] + x[5] = 0 \tag{5}$$

$$x[2] + x[3] + x[4] + x[6] = 0 \tag{6}$$

$$x[3] + x[4] + x[5] + x[7] = 0, \tag{7}$$

where $x[n]$ is the value of the $n^{\text{th}}$ bit. This is the parity check matrix for an $[N=7,k=4,d=3]_{q=2}$ Hamming code.

**Encoders and Decoders for Error-Correcting Codes**

An encoder for a linear $[N, k]_q$ code transforms an information block $u[a]$ consisting of $k$ symbols into a code word $x[n]$ of $N$ symbols. A decoder for a linear $[N, k]_q$ code transforms a distorted version $y[n]$ of a transmitted code word back into the information block $u[a]$.

The distorted version of the transmitted code word is sometimes a word $y[n]$, whose samples take values from the same $q$-ary alphabet as the error-correcting code. Decoders that accept such input signals are often referred to as "hard-input" decoders. Such decoders are useful when the channel corrupts $q$-ary symbols in the code word to other $q$-ary symbols with some small probability. An optimal hard-input decoder for such channels outputs the code word $x[n]$ that has the smallest distance from $y[n]$.

In some applications, the received signal is first transformed into a "cost function," then the cost function is input to the decoder. A cost function is a vector specifying a cost for each possible state of each symbol.

Decoders that accept such input cost functions are often referred to as "soft-input" decoders. For a binary code with block-length of three, an example cost function for a soft-input decoder is [(0.1, 0.3), (0.2, 0 .4), (0.25, 0.15)]. This cost function means that the cost of assigning the first bit the value '0' is 0.1, the cost of assigning the first bit the value '1' is 0.3, the cost of assigning the second bit the value '0' is 0.2, and so on.

An optimal soft-input decoder returns a code word that has a lowest possible summed cost, given the cost function. For example if the three-bit code of the example in the previous paragraph had the two code words (000) and (111), then the code word (000) is returned, because it has a cost of 0.1 + 0.2 + 0.25 =0 .55, while the code word (111) has a cost of 0.3 + 0.4 + 0.15 = 0.85. The cost in a soft-input decoder is often taken to be equal to the negative of the log-likelihood for each bit, given the received signal and the channel model.

Constructing optimal hard-input or soft-input decoders for error-correcting codes is generally a much more complicated problem then constructing encoders for error-correcting codes. The problem becomes especially complicated for codes with large $N$ and $k$. For this reason, many decoders used in practice are not optimal. Non-optimal hard-input decoders attempt to determine the closest code word to the received word, but are not guaranteed to do so, while non-optimal soft-input decoders attempt to determine the code word with a lowest cost, but are not guaranteed to do so.

When soft-input information is available, hard-input decoders can still be used by first thresholding all the soft inputs into symbol decisions that are then input to the hard-input decoder. However, such a procedure usually gives a performance that is significantly worse than the performance that can be achieved using a soft-input decoder.

**Limits on the Optimal Performance of Codes**

Information theory gives important limits on the possible performance of optimal decoders. Some of these results were first proven by C.E. Shannon, in "A Mathematical Theory of Communication," Bell Syst. Tech. Journal, vol 27, pp. 379-423, 623-656, 1948.

Expressed in intuitive terms, Shannon showed that any noisy channel has a *capacity C* that is related to its noisiness, and that optimal decoders of optimal codes can correct all errors if and only if the capacity is greater than the rate of the code.

For many years, Shannon's limits seemed to be only of theoretical interest, as practical error-correcting coding methods were very far from the optimal performance. In the last decade, however, a variety of codes, most prominently turbo-codes, low-density parity check codes, and serially-concatenated accumulate codes, have achieved performance quite close to Shannon's limits. These codes are all decoded using iterative message-passing methods. Serially-concatenated accumulate codes are particularly relevant to the invention, so they are discussed in more detail below.

For example, for an additive white Gaussian noise (AWGN), it has been shown by simulations that one can use low-density parity check codes and iterative message-passing decoders to obtain bit error rates of $10^{-5}$ within 0.0045 dB of the Shannon limit, see S.-Y. Chung, G. Forney, T. Richardson, and R. Urbanke, "On the Design of Low-Density Parity-Check Codes Within .0045 dB of the Shannon Limit," IEEE Communications Letters, vol. 5, pp. 58-60, February 2001.

Counter intuitively, it is important to understand that using *non-optimal* decoders is a key ingredient to closely approach the Shannon limit for the channel coding problem. The explanation of this apparent paradox is that to approach the Shannon limit, codes of very large block-length and dimension must be used. Such long codes cannot normally be practically decoded using optimal decoders.

**Factor Graphs**

Codes can be represented by a factor graph, see F.R. Kschischang, B.J. Frey, and H.-A. Loeliger, "Factor Graphs and the Sum-Product Algorithm," IEEE Transactions on Information Theory, vol. 47, pp. 498-519, February 2001, G.D. Forney, Jr., "Codes on Graphs: Normal Realizations," IEEE Transactions on Information Theory, vol. 47, pp. 520-549, February 2001, and R.M. Tanner, "A Recursive Approach to Low-Complexity Codes," IEEE Transactions on Information Theory, vol. 27, pp. 533-547, September, 1981.

Factor graphs can be drawn in a variety of different forms. The form followed herein is as described by Kschischang et al. A factor graph is a bipartite graph, containing two types of nodes, called "variable nodes" and "factor nodes." Variable nodes are only connected to factor nodes and vice-versa. Herein, factor nodes are drawn using squares, and variable nodes are drawn using circles, and connections between variable and factor nodes are denoted by lines connecting the corresponding circles and squares. Sometimes a symbol, i.e., '+', is drawn inside a factor node to represent the kind of constraint that it enforces. This is the conventional notation used herein.

The simplest factor graph representations of codes are those that correspond to a parity check matrix representation. In such factor graphs, there are $N$ variable nodes that correspond to the $N$ columns of the parity check matrix, and there are M factor nodes that correspond to the *M* rows of the parity check matrix.

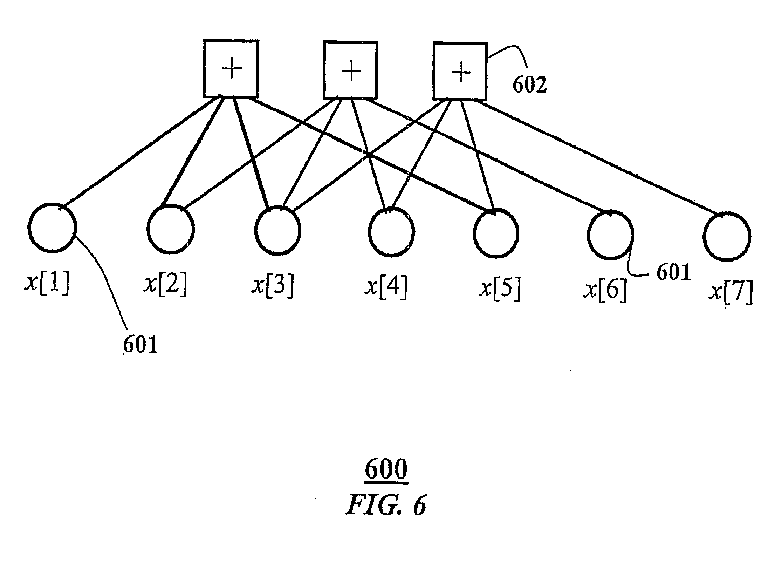

Figure 6 shows a factor graph for the binary Hamming code with parity check matrix given by equation 4 above. In this factor graph representation, the variable nodes 601 correspond to *N* symbols in a code word. These variable nodes are also sometimes referred to as the 'transmitted' symbols. The factor nodes 602 correspond to parity check constraints.

More general factor graph representations of codes are possible. In particular, the set of variable nodes sometimes also includes nodes called "state variable nodes" that help define the code, but are not one of the *N* symbols in a code word.

Sometimes, the factor nodes also represent constraints that are more general than a parity check constraint. For example, a factor node can represent a constraint such that the only acceptable configurations of the variable nodes that connect to it are those that correspond to a code word of some small code. In this way, large codes can be built recursively out of small codes.

**Syndromes**

For any [*N, k*] block code, the "syndrome" for any word is defined as a set of *N - k* linearly independent symbols that are all zero when the word is a code-word. The syndrome for a code is often defined using a parity check matrix. Any code-word of a code satisfies all of the parity check constraints represented by a parity check matrix for that code. Other words that are not code-words do not satisfy all the parity check constraints. If a word *y* is represented by a row vector of *N* zeroes and ones, then the "syndrome" *s* of the word *y* is a row vector can be defined by

$$s^T = Hy^T, \tag{9}$$

where the *T* superscript represents a transpose. Assuming that *H* is an *N-k* by *N* parity check matrix, then the syndrome *s* has *N-k* components. If *y* is a code-word, then the syndrome s is necessarily a vector of *N-k* zeros.

For example, taking the word *y* = (0000001), then the syndrome of that word, using the parity check matrix for the Hamming code given in equation 4 above, is *s* = (001). This means that for the word *y*, the first two parity checks of *H* are satisfied, but the third is not.

The factor graph of a code can be modified so that it also includes its syndrome bits. One simply adds new variable nodes corresponding to the syndrome bits, and attaches the syndrome nodes to other nodes in a way that properly reflects their relationship to other codeword symbols.

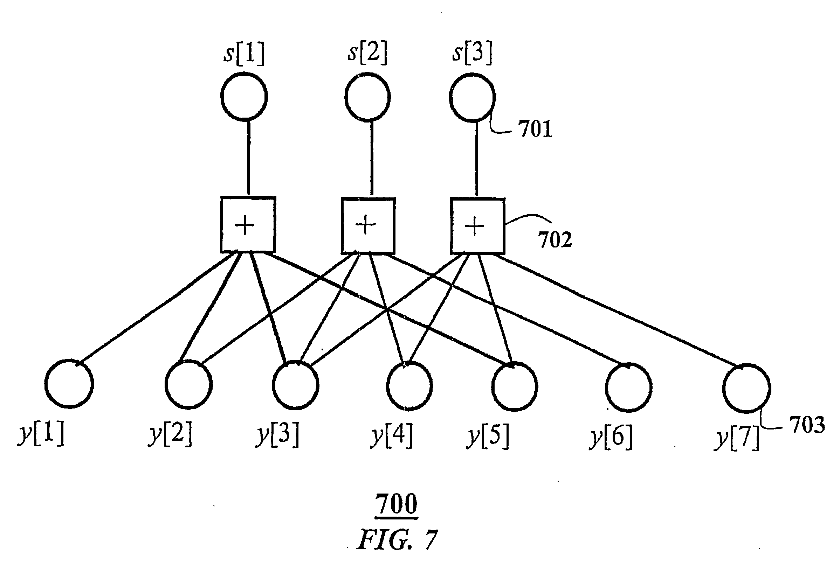

For example, Figure 7 shows an extended factor graph 700 of the Hamming code, with three variable nodes representing the syndromes. In Figure 7, the three syndrome nodes *s*[1], *s*[2], and *s*[3] for variable nodes 703, are represented by syndrome nodes 701 attached to the parity check factor nodes 702.

Note that in the ordinary factor graph for a code, the *N* variable nodes representing transmitted symbols are in a collective state that corresponds to a code word. On the other hand, in the extended factor graph that includes syndrome variable nodes, the *N* variable nodes representing transmitted symbols can be in any collective state, and are only in a code word when all the syndrome variable nodes are zero.

More generally, the syndrome bits for any error correcting code can be *defined* graphically, by extending the factor graph representing the code to include syndrome nodes corresponding to the desired syndrome bits.

A *coset code-word* of a code is defined to be a word that satisfies all the syndromes. If the syndromes are all zero, then the coset code-word is an ordinary code-word.

**Syndrome-Based Source Coding**

Consider the Slepian-Wolf problem in the case where a first encoder simply encodes a first signal without considering a second signal, while a second encoder tries to take into account the correlation between the two signals. This particular case of the Slepian-Wolf problem is called "source coding with side information." Taking Y to be the signal that is encoded directly, that means that the first encoder compresses at a rate close to $H(Y)$ bits per symbol, while the second encoder compresses at a rate close to $H(X|Y)$ bits per symbol, for a total rate near $H(X,Y)$ bits per symbol.

In his 1974 paper mentioned previously, Wyner describes how to solve encoding problems involving source coding with side information. This idea is illustrated with the following small example. This example should not be interpreted as a realistic method for compression of real-world signals for reasons that will become clear below.

Suppose that the sources X and Y both emitted signals consisting of seven bits, which are random, identically independently distributed, and equally likely to be zeros and ones, but correlated in the sense that they never differ from each other by more than a single bit. As an example, the source X emits a signal *X* = (0010100) and the source Y emits a signal $Y$ = (0011100). These two signals only differ by one bit. Such joint signals costs a conventional encoding system that examines both signals a total of ten bits to encode: seven bits to encode the signal $Y$, plus three bits to encode the difference of the signal $X$ from the signal $Y$. The reason that it takes three bits to encode the difference of $X$ from $Y$ is that there are seven positions where $X$ could differ from $Y$, plus it might not differ at all, for a total of eight possibilities, which takes three bits to encode. The above method can be implemented when the encoder has access to both sources X and Y.

If there is only access to one of the two encoders, then a syndrome-based method can send the signal Y through directly, costing seven bits, and the encoder for the signal $X$ sends the syndrome of the signal $X$ with respect to a [$N$=7, $k$=4, $d$=3] Hamming code. For example, if the source X emits (0010100) and the parity check matrix of the code is given by equation (4) above, then the syndrome computed using equation (9) is (010). Thus a total of ten bits are sent by the encoders in the syndrome-based method.

The decoder in a syndrome-based method operates as follows. The decoder knows that the signal $Y$ was sent through correctly with no compression, and the decoder knows that $X$ differs from $Y$ by no more than a single bit, and the decoder has received the syndrome. Thus, the decoder searches for the word that satisfies the syndrome, and differs from $Y$ by no more than one bit. Because of the structure of the [$N$=7, $k$=4, $d$=3] Hamming code, there is always exactly one word satisfying these conditions.

### Requirements for a Practical Syndrome-Based Coding Method

The above example illustrates the basic idea behind syndrome-based coders, but the syndrome-based encoder and decoder described above are of limited use for practical application. To be useful in real-world applications, a syndrome-based coding method should satisfy the following requirements.

First, the method should be capable of encoding integer-valued symbols having a large range of possible values, rather than simply bits taking on the two values zero or one. Most signals encountered in real applications are integer or real-valued. For example, the intensity values of pixels in a video stream typically take on integer values from 0 to 255. Real-valued signals are normally quantized to integer values, and typically a large number of quantization levels are used to minimize distortion.

Second, the method should be capable of encoding to very high compression rates. In many applications, such as video compression, there is a great deal of redundancy in the signals acquired by the source (camera). A good compression scheme should be able to take advantage of all the redundancy, and thus should be able to compress, for example, to ratios of 100:1 1 in a graceful way.

Third, the method should be rate-adaptive. None of the prior art syndrome coders are rate adaptive. Thus, those coders are essentially useless for real-world signals with varying complexities and variable bit rates. In many situations, the amount of entropy in a source stream changes from one instant in time to the next. For example, a video stream might have a section where adjacent frames are identical, which would be highly compressible because the level of redundancy is high, followed by frames of a rapidly changing scene, which would be much less compressible because the level of redundancy is low. The method should be able to change compression rates smoothly and without changing the underlying code.

Fourth, the method should be incremental. In other words, the encoder should be able to send a certain number of syndrome bits, and then if more bits are requested by the decoder, send useful additional bits without having to waste bits decoding the information previously sent. This incremental property is very useful for those applications where a small feedback channel exists, so that the decoder can inform the encoder whether decoding was successful or not.

Fifth, the method should achieve compression efficiencies near the bounds described by Slepian-Wolf for lossless compression and Wyner-Ziv for lossy compression. For this to be possible, the method needs to be based on an error-correcting code that approaches the Shannon limit for the channel coding problem.

Sixth, the method should use encoding and decoding methods that are simple. In particular, the complexity of the encoder and decoder should scale in a reasonable way, e.g., linearly, with the number of source symbols $N$. This is necessary as a large number of source symbols normally need to be compressed together in order to achieve performance near the bounds that Shannon promised were possible. Specifically, it is desired to have the encoder be quite simple.

### Serially Concatenated Accumulate Codes

The invention uses codes derived from so-called "repeat-accumulate codes," namely "product-accumulate codes," and codes called "extended Hamming-accumulate codes." Collectively, this class of codes is called "serially concatenated accumulate" (SCA) codes. By an SCA code, we specifically mean a code whose encoder consists of a set of encoders of base codes, followed by a permutation, followed by a rate-1 accumulator code.

Repeat-accumulate (RA) codes are an example of SCA codes, where the base codes are repetition codes, see D. Divsalar, H. Jin, and R. J. McEliece, "Coding Theorems for 'turbo-like' codes," Proceedings of the 36th Allerton Conference on Communication, Control, and Computing, pp. 201-210, Sept. 1998.

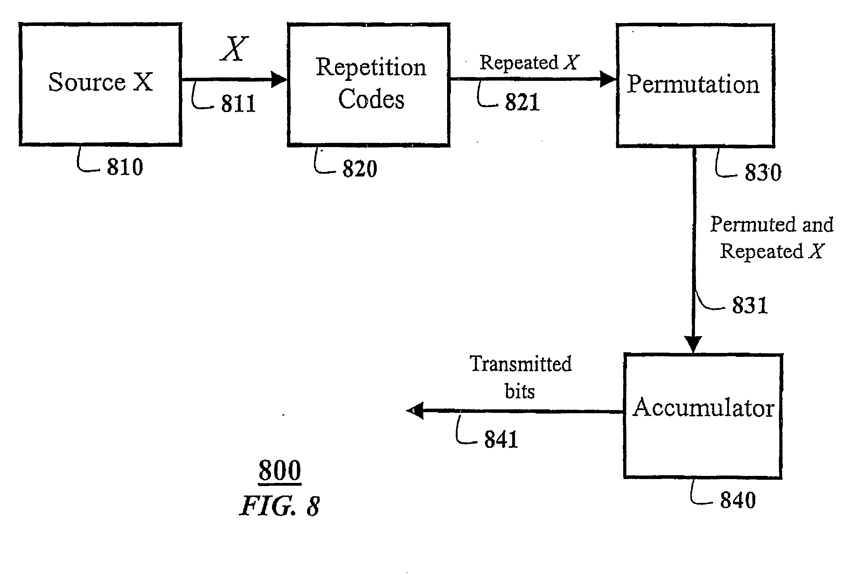

Figure 8 shows an encoder 800 for an RA code. A source X 810 emits a signal *X* 811. The encoder first repeats 820 each bit in the signal *X*. The encoder then permutes 830 the resulting set of repeated bits 821. The permuted bits 831 are then sent through an accumulator 840, resulting in a set of transmitted bits 841. Note that the accumulator can be considered a rate-1 code.

As an example of an RA code, consider a small [*N=9, k=3*] RA code that uses three [*N=3, k=1, d=3*] repetition codes. This repetition code simply encodes a one bit as (111), and a zero bit as (000). If the information block for the RA code is (101), then the repetition codes 820 convert this to (111000111). The permutation 830 permutes these bits according to some fixed rule. RA codes are often designed using permutations that are selected randomly. Assume for the sake of this example that the permutation is (123456789) $\rightarrow$ (369274158), which means that the first bit gets permuted to the third position, the second bit is permuted to the sixth position, and so on. Then, the bits (111000111) are permuted to (101011011). The last stage of the RA code is the accumulator, which is a rate-1 code. The accumulator 840 keeps a running sum, modulo-2, of the permuted bits. Thus, (101011011) is transformed by the accumulator to the word (110010010), which is the code word 841 that is transmitted by the RA encoder. Note that the rate of an RA code is equal to the rate of its constituent repetition codes, if those constituent codes are all identical.

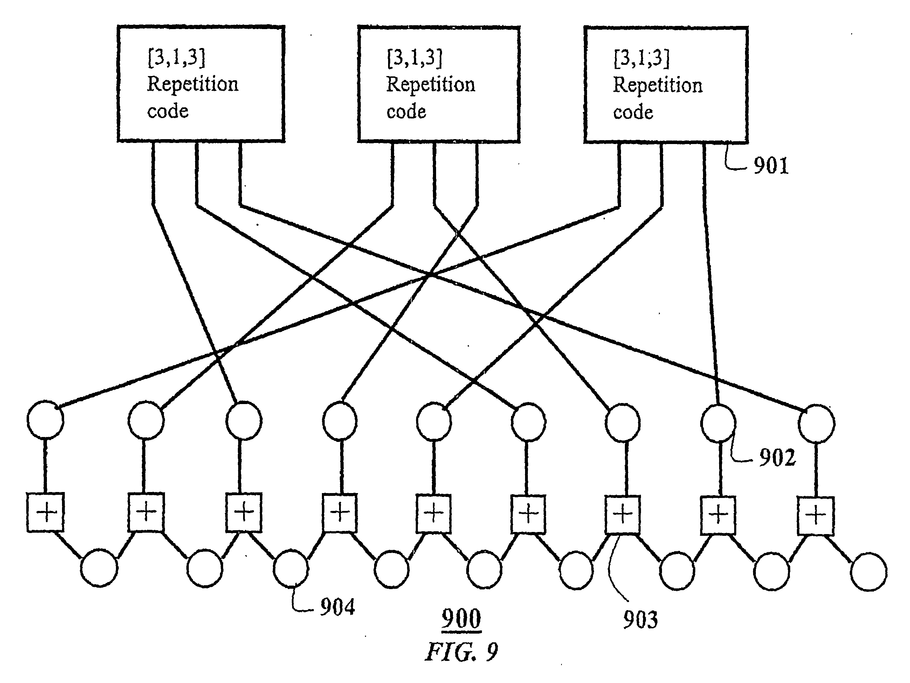

Figure 9 shows a factor graph 900 for the example RA code considered above, with repetition codes 901, variable nodes 902, factor nodes 903, and transmitted bits 904.

RA codes are usually decoded using an iterative message-passing method. In such a method, the evidence from the channel is fed into a Bahl, Cocke, Jelinek, and Raviv (BCJR) decoder for the rate-1 accumulator, see L.R. Bahl, J. Cocke, F. Jelinek, and J. Raviv, "Optimal Decoding of Linear Codes for Minimizing Symbol Error Rate," IEEE Transactions on Information Theory, vol. 20, pp. 284-287, 1974. The BCJR decoder outputs a set of optimal *a posteriori* probability estimates for each of the permuted bits, given the input and the structure of the accumulator code. These estimates are then fed into a decoder for the repetition codes, which output a new set of *a posteriori* probability estimates for the permuted bits. The *a posteriori* estimates for each repetition code are optimal given the inputs. The estimates are fed back into the BCJR decoder of the accumulate code. The process is iterated, until the probability estimates, when projected to their most likely values, correspond to a codeword, or until a fixed number of iterations has been reached. It should be understood that the described decoding method for RA codes is not optimal, even though the decoders are optimal for each of the sub-codes in the RA code.

The difference between the RA code and a product-accumulate (PA) code is that in the PA code the repetition codes are replaced by product codes of single parity check (SPC) codes, see J. Li, K.R. Narayanan, and C.N. Georghiades, "Product Accumulate Codes: A Class of Codes With Near-Capacity Performance and Low Decoding Complexity," IEEE Transactions on Information Theory, vol. 50, pp. 31-46, January 2004. In the product code, every code word symbol is simultaneously part of a code word for two separate single parity check (SPC) codes. Product codes of SPC codes have a particularly simple structure, wherein every codeword symbol satisfies two parity checks.

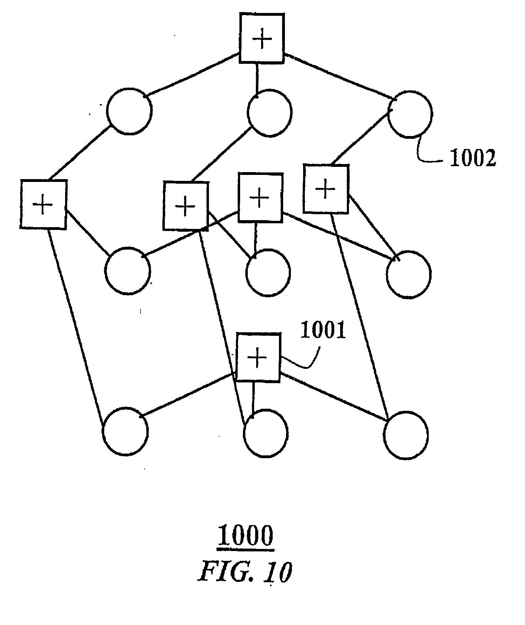

Figure 10 shows a factor graph 1000, with factor nodes 1001 and variable nodes 1002, for a [*N=9,k=4,d=4*] product code of single parity check codes. The parity checks in the substantially horizontal direction of this factor graph are called "horizontal" parity checks, and those in the substantially vertical direction are called "vertical" parity checks.

A product code of SPC codes that has *L* horizontal parity checks and *M* vertical parity checks has a rate equal to $(L-1)(M-1)/(LM)$. Thus, if *L* and *M* are selected to be large, then the rate of the product code of SPC codes is close to one. A PA code has a high rate, close to one, if the code constituent product codes have a high rate.

PA codes are decoded similarly to RA codes. The major difference is that an optimal decoder for the product codes is not feasible, so an approximate decoding is used for the product codes.

Extended Hamming Accumulate (EHA) codes are also similar to RA codes, except that the repetition codes in RA codes are replaced with extended Hamming codes, see M. Isaka and M. Fossorier, "High Rate Serially Concatenated Coding with Extended Hamming Codes," submitted to IEEE Communications Letters, 2004, and D. Divsalar and S. Dolinar, "Concatenation of Hamming Codes and Accumulator Codes with High Order Modulation for High Speed Decoding," IPN Progress Report 42-156, Jet Propulsion Laboratory, Feb. 15, 2004. Extended Hamming codes have the following parameters: $N=2^R$, $k=N-R-1$, and *d=4,* for all integers *R* greater than or equal to two. Thus, the first few extended Hamming codes have parameters [*N=4,k=1,d=4*], [*N=8, k=4, d=4*], [*N= 16, k=11, d=4*], and [*N=32, k=26, d=4*].

Extended Hamming codes have practical decoders that correctly determine the *a posteriori* probability estimates given *a priori* probability estimates. Therefore, EHA codes can be decoded using these decoders for the extended Hamming codes, and BCJR decoders for the accumulator. One advantage of EHA codes, as compared to PA codes, is that they can be designed for high rates at shorter block lengths compared to equal rate PA codes.

Other SCA codes can readily be constructed by replacing the repetition code in a repeat-accumulate code by some other code.

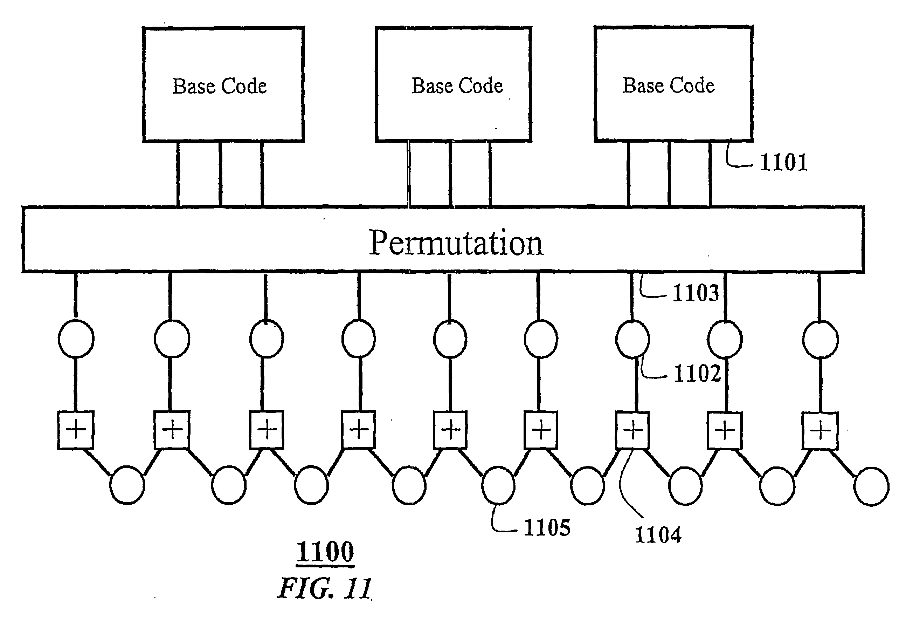

Figure 11 shows the general structure of a factor graph 1100 for a SCA code. The "base codes" 1101 used in the top layer of this factor graph depend on the type of SCA code. The base codes are repetition codes for RA codes, products of single parity check codes for PA codes, or extended Hamming codes for EHA codes. The number of variable nodes 1102 connected to each base code is equal to the block-length of that base code. Block 1103 is the permutation, and blocks 1104 the factor nodes, and blocks 1105 the transmitted bits.

### Multi-Stage Decoders

Multi-stage decoders can also be designed for the channel coding problem, see H. Imai and S. Hirikawa, "A New Multilevel Coding Method Using Error-Correcting Codes," IEEE Transactions in Information Theory, vol. 23, pp. 371-376, May 1977. Multi-stage decoders have been used to decode multi-level block modulation codes, see for example, chapter 19 of the book by Lin and Costello cited above.

### Prior-Art Syndrome-Based Distributed Compression Methods

Recently, there have been some proposals for practical syndrome-based compression methods, although none satisfy all the requirements listed above. Recall that the following features are desired of a syndrome-based decoder: (1) it should compress integer-valued inputs of a wide range, (2) it should be capable of high compression rates, (3) it should be rate-adaptive, (4) it should be incremental, (5) it should approach the Slepian-Wolf and Wyner-Ziv limits, and (6) it should have a low complexity.

One approach uses trellis (convolutional) codes, S.S. Pradhan and K. Ramchandran, Distributed Source Coding Using Syndromes (DISCUS): Design and Construction, IEEE Transactions on Information Theory, vol 49, pp. 626-643, March 2003. Because their approach uses a quantizer, they are able to handle real-valued inputs and integer inputs with a wide range. However, their codes do not allow very high compression rates, and the rates are substantially fixed. It is highly desired to be able to encode adaptively. In addition, the Pradhan and Ramchandran's approach is not incremental in the sense described here. Because their method is not based on capacity-approaching channel codes, its compression performance is limited. The performance is also limited by the fact that only hard-input (Viterbi) decoders are used in that method, so soft-input information cannot usefully be used. In summary, the Pradhan and Ramchandran satisfies some of the requirements, but fails on the requirements of high compression rate, graceful and incremental rate-adaptivity, and performance approaching the information-theoretic limits.

Another approach uses low-density parity check (LDPC) codes as the basis of a syndrome-based decoder, see A. Liveris, Z. Xiong and C. Georghiades, "Compression of binary sources with side information at the decoder using LDPC codes," IEEE Communications Letters, vol. 6, pp. 440-442, October 2002. That method does not allow for integer inputs with a wide range. Because it is difficult to generate LDPC codes that perform well at very high rate, that method also does not permit very high compression ratios. That method also does not allow for incremental rate-adaptivity, which is essential for signals with varying data rates over time, such as video signals.

Another appraoch uses bit-planes, which are encoded using LDPC codes, see Sehgal A. et. al, "A state-free causal video encoding paradigm" Proceedings 2003 International Conference on Image Processing, vol 2 of 3, pages 605-608.

In summary, there is no prior-art method that satisfies all the requirements listed above for a practical syndrome-based coding method, and it is an object of the present invention to satisfy all of these requirements.

### Disclosure of Invention

The present invention provides a method and system for encoding an input signal of $N$ samples that is correlated with one or more other input signals as a syndrome signal. In addition, the invention provides a corresponding method to decode the syndrome bit-stream to recover the original input signal.

The method can be applied to lossy compression of real-valued or integer-valued signals by first transforming and quantizing the input signals to integers. Therefore, all the signals are optionally pre-processed by standard transformation and quantization methods that convert the input signals to integers having a convenient range.

The coding operates as follows. An initial signal is encoded conventionally. The initial encoded signal serves as initial side information for all subsequent signals from all sources. All other signals are encoded only to syndrome bits in the form of bit-planes.

The number of syndrome bits sent for each bit-plane is determined by the encoder, using either a feedback channel from the decoder, or from an estimation based on a conditional probability distribution between signals.

The serially concatenated accumulate (SCA) code that is used for each bit-plane is based on the number of syndrome bits that need to be sent. The code is adjusted incrementally by successively partitioning base codes, e.g., either a product code or an extended Hamming code, in the SCA code. This makes the encoding rate adaptive, which is a highly desirable feature not available in prior art syndrome coders. The base codes are partitioned according to a predetermined schedule that is also known by the syndrome decoder.

The syndrome encoder, based on the SCA code, produces syndrome bits as follows. First, the bits in a bit-plane from a source are input to an inverse accumulator, followed by an inverse permutation and then the syndrome bits are determined using the parity checks in the base code of the SCA code.

The decoding method reconstructs the input signals as follows. The encoded signal is reconstructed using available side information and the syndrome bits. The decoded signal, after reconstruction, is used as side information for a next signal, and so on.

The number of syndrome bits sent for each signal is used together with the predetermined block code partitioning schedule, to determine the sizes of the block codes in the decoder.

Each signal is represented by a set of bit-planes, which are decoded using a multi-stage decoder. The bit-planes are decoded in a predetermined order. *A priori* probabilities of the bits in the first bit-plane are estimated based on a probability distribution. Probabilities in subsequent bit-planes are based on the probability distribution, conditioned on the results of previously decoded bit-planes.

The *a priori* probabilities are used as inputs to the decoder of serially concatenated accumulate codes, suitably modified so that the received syndromes are correctly satisfied.

**Brief Description of the Drawings**

Figure 1 is a block diagram of a prior art Slepian-Wolf compression system;

Figure 2 is a block diagram of a prior art compression system;

Figure 3 is a block diagram for a prior art compression system operating on correlated signals;

Figure 4 is a graph of the prior art minimum number of bits to be sent to determine reconstruction possibilities;

Figure 5 is a block diagram of a prior art method for a channel coding problem;

Figure 6 is a factor graph for a prior art Hamming code;

Figure 7 is an extended factor graph for a prior art Hamming code, including variable nodes corresponding to syndrome bits;

Figure 8 is a block diagram of a prior art encoder of a repetition-accumulate (RA) code;

Figure 9 is the factor graph for a prior art example RA code;

Figure 10 is the factor graph for a prior art product of single parity check codes;

Figure 11 is a factor graph for a prior art serially-concatenated accumulate (SCA) code;

Figure 12 is a block diagram for an encoder according to the invention;

Figure 13 is an extended factor graph for a product-accumulate (PA) code, including syndrome bits according to the invention;

Figure 14 is a block diagram for a syndrome bit encoder using a PA code according to the invention;

Figure 15 is an extended factor graph for an extended-Hamming-accumulate (EHA) code, including syndrome bits according to the invention;

Figure 16 is block diagram of an extended factor graph for an 8 by 8 product of single parity check codes according to the invention;

Figure 17 is a block diagram of an extended factor graph for two 8 by 4 products of single parity check codes according to the invention;

Figure 18 is a block diagram for a decoder according to the invention;

Figure 19 is a block diagram for a multi-stage syndrome decoder according to the invention;

Figure 20 is a block diagram of a syndrome-modified SCA decoder according to the invention; and

Figure 21 is a block diagram of an inverse transformation according to the invention.

**Best Mode for Carrying Out the Invention**

**Overall Structure of Syndrome Encoder**

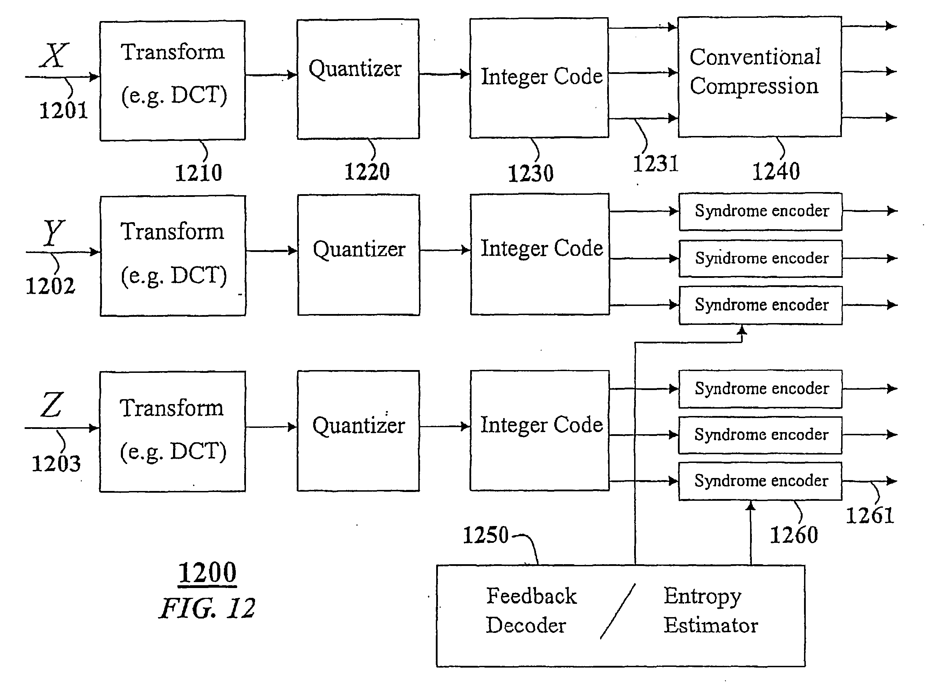

Figure 12 shows an encoder 1200 according to our invention. The encoder includes transforms 1210, quantizers 1220, integer codes 1230, compression modules 1240, a feedback decoder and entropy estimator 1250, and syndrome encoders 1260. The transform, quantizer, coder, and compressor are serially connected for each input signal 1201-1203 to be encoded.

In the first two optional steps, the signals are transformed 1210 and quantized 1220 so that the signal can be represented by $N$ integers, taking on $2^B$ possible values. We refer to $B$ as the number of bit-planes. An example of the kind of transform that can be used is a discrete cosine transform (DCT).

Next, the integers are coded 1230 into B bit-planes 1231.

Then, each bit-plane is compressed 1240 separately. The bit planes of the first signal 1201 are encoded conventionally. All other signals are encoded into syndrome bits.

The number of syndrome bits 1261 generated by the syndrome encoders 1260 can be estimated by two methods. In the first method, we assume that the feedback decoder 1250 can indicate whether or not the decoder was able to decode a previously transmitted encoded signal. The encoder keeps sending bits until acknowledgement is received that a decoding was successful. This method relies on the fact that the syndrome bits can be sent in an incremental way, as described below. This method has the advantage that a minimal number of syndrome bits are sent and that the decoding is always successful.

In the second method, a conditional entropy is estimated based on a conditional probability distribution. The number of syndrome bits is made larger than the conditional entropy so that one can be confident that the decoding succeeds.

**Selecting Compression Mode**

For each signal, a decision is made as to whether to send the signal using a conventional encoder, or by using syndrome bits. $T$ signals are labeled $X_A, X_B, X_C, ...., X_T$. For some applications, the labels on the different signals can be interpreted as time indices. For simplicity, we assume that a joint probability distribution of the signals $p(x_A, x_B, x_C, ..., x_T)$ has a Markov structure, that is:

$$p(x_A, x_B, x_C, ...., x_T) = p(x_A)p(x_B \mid x_A)p(x_C \mid x_B)...p(x_T \mid x_S). \qquad (10)$$

Below, we describe modifications that can be made when the joint probability distribution does not have the Markov structure.

Assuming the Markov structure, the encoder and decoder operate as follows. The signal $X_A$ is encoded conventionally to about $H(X_A)$ bits, without any reference to its correlation to any other signals. The signal $X_B$ is compressed to about $H(X_B|X_A)$ syndrome bits, the signal $X_C$ is encoded to about $H(X_C|X_B)$ syndrome bits, and so on. The decoder recovers the signal $X_A$. The recovered signal $X_A$ is used to recover the signal $X_B$, and the recovered signal $X_B$ is used to recover $X_C$, and so on.

The problem to be solved is how to use a previously decoded signal to decode the next signal, even when the encoder does not have access to all of the signals. In general, the general distributed source coding problem with many signals can be solved by solving one source coding with side information (SCSI) problem at a time.

Even if the joint probability distribution does not have a simple Markov structure, the distribution normally has a structure that can be modeled as a Bayesian network. Assume for example, that the structure of the joint probability distribution is

$$p(x_A, x_B, x_C, ...., x_T) = p(x_A)p(x_B)p(x_C \mid x_A, x_B)p(x_D \mid x_B, x_C)....p(x_T \mid x_R, x_S).$$

To recover a next signal, two previous signals are first recovered, and a conditional probability distribution function that depended on both of those previous signals is used to recover the next signal. It should be noted, that the two previous signals can be obtained conventionally.

We assume that the joint probability distribution between the signals has a simple Markov structure. Thus, the first signal is encoded and decoded conventionally, and syndrome bits are used for all other signals, which are reproduced sequentially using side information from previously reconstructed signals.

**Pre-Processing**

The encoder takes as input a signal in the form of $N$ integer samples. The integer values of each sample have a range of $2^B$ possible values, where $B$ is an integer. For example if $B$ is six, then each sample can take on sixty-four possible values.

If the signal has a different format, then the pre-processing steps 1210 and 1220 can be performed. For example, if the signal includes real-values or integers larger than $2^B$, then the quantization can convert the signal to integers that have a range of $2^B$ possible values.

Alternatively, the quantizer 1220 can be preceded by the transform step 1210. For example, the transform step can be used if the signals to be encoded are two-dimensional images. Each image can be partitioned into macroblocks, and the DCT 1210 can be applied to each macroblock. The coefficients of the DCT are then quantized 1220. Such a macroblock transform is useful for reducing correlations within the signal, and are a standard part of many image and video compression methods.

It may be desired to quantize the transform coefficients to a different number of bit-planes depending on their significance. In such a case, all the coefficients that have the same significance are encoded separately as a group. The important point is that the pre-processing guarantees that each signal is converted into groups of $N$ integer-valued samples that each can take on $2^B$ possible values.

In the preferred embodiment of the invention, $N$ is very large number, of the order of a thousands or larger. To make the description our examples manageable, we use examples with a smaller $N$. The reason that a large value for $N$ is preferred is that large block-length encoding and decoding methods can approach the optimum information-theoretic source coding limits described above. To approach the optimal limits for the channel coding problem, codes of large block-length are used, and similarly, to achieve the optimal limits for the distributed source coding problem, encoders and decoders that process long or large signals are used.

**Selecting a Bit-Plane Integer Code**

Each of the $N$ integers of the signal is coded 1231 by an integer code 1230. For example, if the integers have a range of zero to fifteen, then the most straightforward coding over four bit-planes maps zero to 0000, one to 0001, two to 0010, three to 0011, four to 0100, and so on. Other codes, such as Gray codes, can be used.

**Computing Syndromes Using Serially-Concatenated Accumulate Codes**

The first signal is encoded 1240 conventionally; and subsequent signals are encoded into syndrome bits 1261. The syndrome bits are generated by syndrome encoders 1260 using SCA codes. We prefer PA codes and EHA codes as described above.

Each of the $N$ integers from can take on one of $2^B$ possible values. Therefore, we use a set of $B$ SCA codes, one for each bit-plane. For each bit-plane we can adaptively adjust the rate of the SCA code that is used.

For example, if $N$ can be factored into a product $N = LM$, where $L$ and $M$ are integers that are approximately equal in magnitude, then we can use PA codes. A highest rate PA code for each bit-plane uses a single product of SPC codes. The highest rate PA code has a rate $(L\text{-}1)(M\text{-}1)/LM$.

Alternatively, if $N$ is a sum of powers of two, then EHA codes can be used. For example, if $N=192,$ an EHA code with an [$N = 128, k = 120$] extended Hamming code and an [$N = 64, k = 57$] extended Hamming code can be used. In this example, the [$N = 128, k = 120$] code generates eight syndrome bits and the [$N=64, k = 57$] code generates seven syndrome bits, for a total of fifteen syndrome bits.

For each bit-plane, the particular code used is adjusted so that sufficient syndrome bits are sent for decoding to be successful. In other words, our encoding is rate adaptive.

**Determining Syndrome Bits for PA Codes**

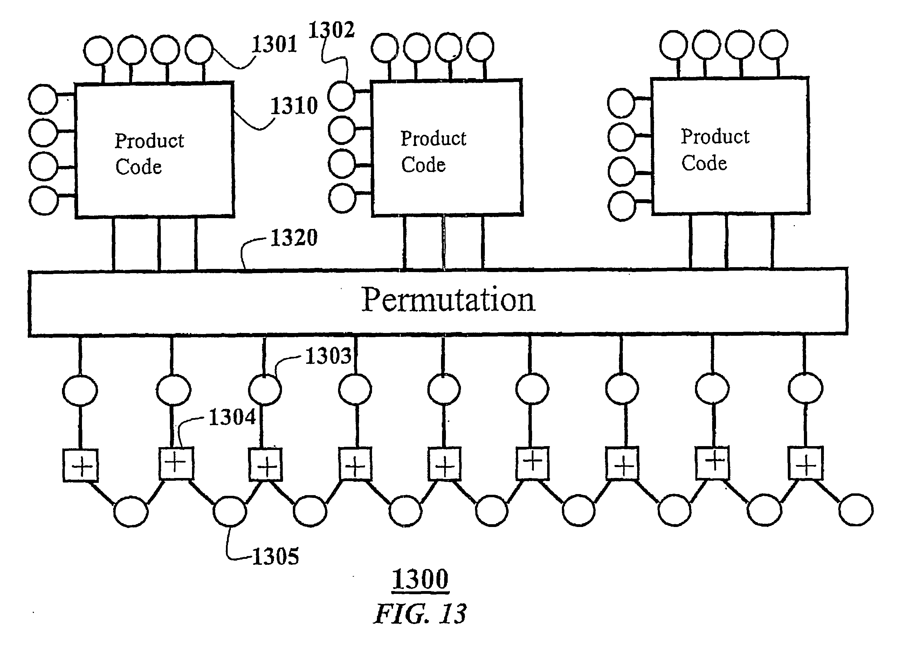

Figure 13 shows an extended factor graph 1300 for a PA code, with syndrome bits added. This extended factor graph can be used as the basis for the encoder for the syndrome bits for PA codes. The variable nodes 1305 are source bits, while the variable nodes 1301-1302 attached above and to the side of the product code 1310 are syndrome bits. Block 1320 is the permutation, and the graph also includes variable nodes 1303, and factor nodes 1304.

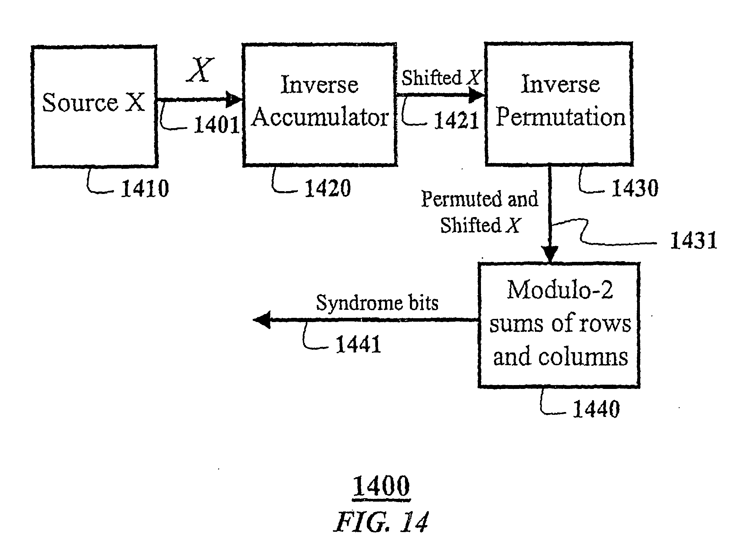

Figure 14 shows a corresponding encoder 1400. A source X 1410 generates a signal *X* 1401. *N* bits of a single bit-plane are sent through an inverse accumulator 1420. The inverse accumulator determines the modulo-2 sum of neighboring bits. The first bit is always modulo-2 summed with zero. For example, the *N* = 6 sequence of bits (101110), when sent through the inverse accumulator, is transformed to (111001). We refer to the bits that come out of the inverse accumulator as "shifted bits" 1421.

The shifted bits are permuted 1430, using an inverse of the permutation used to define the PA code.

The shifted and pennuted bits 1431 are arranged into rectangles corresponding to the products of single parity checks in the PA code, and the modulo-2 sum of each row and column is determined 1440. These modulo-2 sums are the syndrome bits 1441.

In an equivalent way of describing the encoding, the *N* bits in each bit-plane are assigned to their variable node positions in the factor graph, and then all the other variable nodes are determined based on the variable nodes that are already determined. First, the shifted bits are determined from the source bits, and then the syndrome bits are determined from the shifted bits.

## Computing Syndrome Bits for EHA Codes

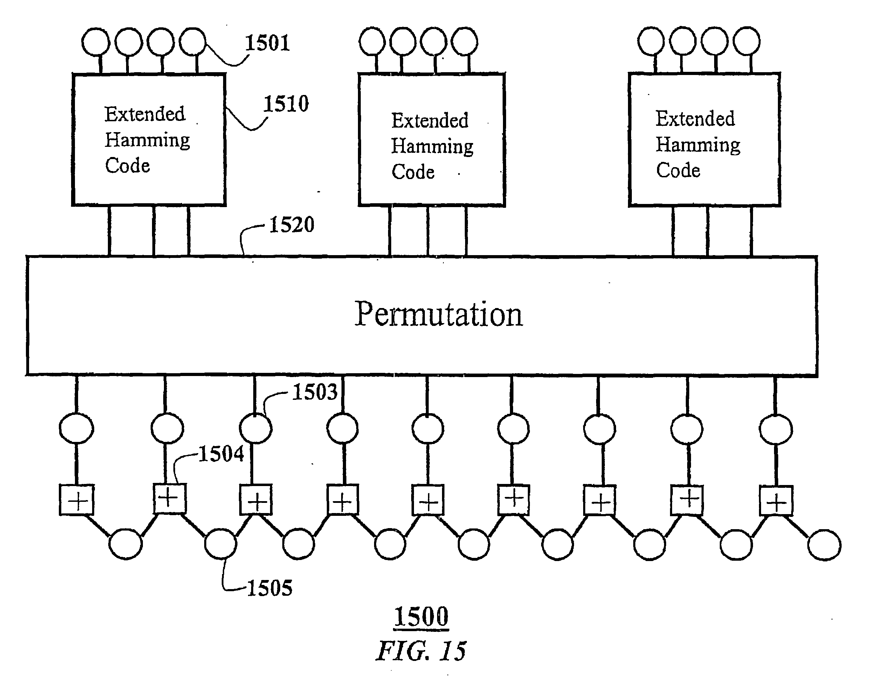

Figure 15 shows an extended factor graph 1500 for an EHA code with syndrome bits added. This extended factor graph can be used as the basis for an encoder of syndrome bits for EHA codes.

The steps for encoding the syndrome bits of an EHA code are identical to those for a PA code, as shown in Figure 13, until the last step, when the parity checks of an extended Hamming code 1510 are used to compute the syndrome bits instead of the product of single parity checks. The variable nodes 1505 are source bits, while the variable nodes 1501 attached above the Hamming code 1510 are syndrome bits. Block 1520 is the permutation, and the graph also includes variable nodes 1503, and factor nodes 1504.

## Incrementally Changing the Rate of PA Codes

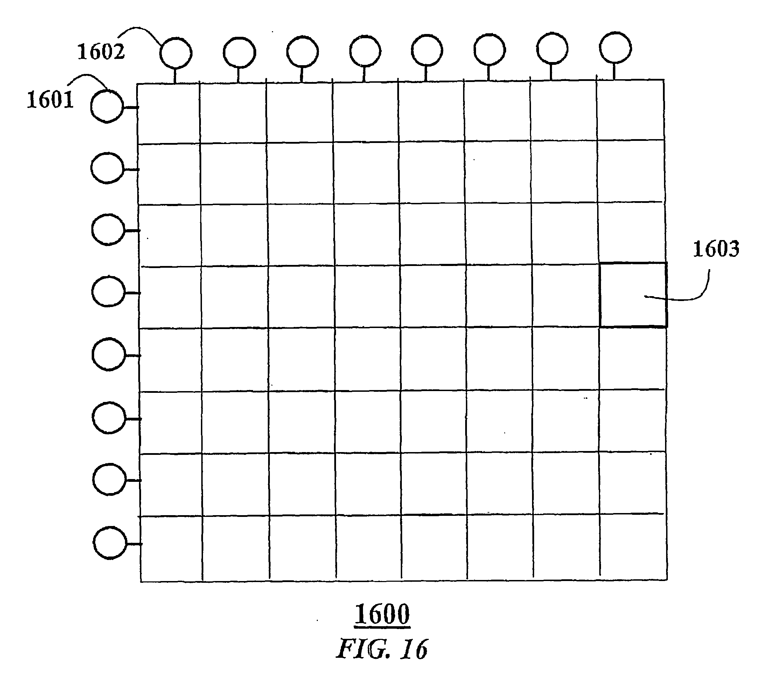

As shown in Figure 16, if a PA code is used, then the number of syndrome bits used for each bit-plane can increase incrementally as follows. If *N* = 64, and the highest rate PA code uses an 8 by 8 product of single parity check codes, then Figure 16 represents this code with an 8 by 8 lattice 1600, with one variable node 1601 representing a syndrome bit associated with each row and another variable node 1602 associated with each column. Each square 1603 in the lattice represents a variable node that is involved in two parity checks, one parity check with all the other variable nodes and the syndrome bit in the same row, and one parity check with all the other variable nodes and the syndrome bit in the same column. This code uses sixteen syndrome bits, one for each row and one for each column.

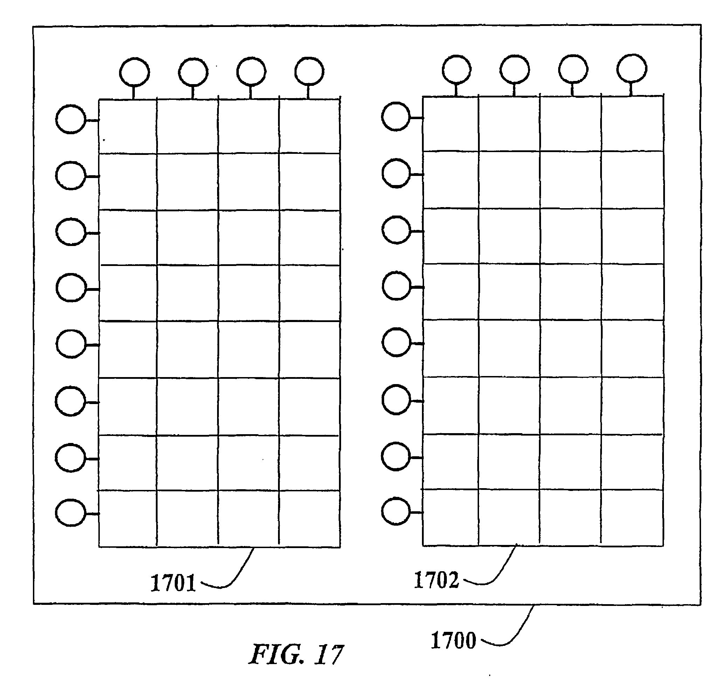

Suppose that an additional eight syndrome bits need to be sent. To do this, as shown in Figure 17, the graph 1700 representing the 8 by 8 product code is partitioned into two eight by four product codes 1701-1702. The eight syndrome bits corresponding to the eight rows of four bits in the product code 1701 are now determined and sent. The eight syndrome bits corresponding to the eight rows of four bits in the product code 1702 are not sent, and instead are determined directly from the syndrome bits already sent for the eight bit rows, and from the syndrome bits already sent for the hand product code 1701.

If more bits need to be sent, each of the 8 by 4 product codes can be further partitioned into 4 by 4 product codes, and the syndrome bits corresponding to the columns of one of those product codes can be sent. One can again avoid sending additional syndrome bits for the columns of the other new product code, because those bits can be determined from the syndrome bits that were previously sent.

This procedure can be iterated. Each product of SPC code can be partitioned into two product of SPC codes when additional syndrome bits need to be sent. The additional syndrome bits are sent directly, while the syndrome bits for the other code are not sent, because those bits can be determined from previously transmitted syndrome bits. In this way, all the necessary syndrome bits can be sent in an incremental way, without wasting the information contained in the syndrome bits that were previously sent.

## Incrementally Changing the Rate of EHA codes

If the EHA code is used, then the number of syndrome bits used for each bit-plane can be increased incrementally as follows. Suppose, as an example, that one of the base codes in the EHA code is a [*N=16,k=11,d*=4] extended Hamming code. The parity check matrices of extended Hamming codes have a very regular structure. For example, the parity check matrix of an [*N* = 16, *k* = 11, *d* = 4] extended Hamming code is a

$$H = \begin{pmatrix} 1 & 1 & 1 & 1 & 1 & 1 & 1 & 1 & 1 & 1 & 1 & 1 & 1 & 1 & 1 & 1 \\ 1 & 1 & 1 & 1 & 1 & 1 & 1 & 1 & 0 & 0 & 0 & 0 & 0 & 0 & 0 & 0 \\ 1 & 1 & 1 & 1 & 0 & 0 & 0 & 0 & 1 & 1 & 1 & 1 & 0 & 0 & 0 & 0 \\ 1 & 1 & 0 & 0 & 1 & 1 & 0 & 0 & 1 & 1 & 0 & 0 & 1 & 1 & 0 & 0 \\ 1 & 0 & 1 & 0 & 1 & 0 & 1 & 0 & 1 & 0 & 1 & 0 & 1 & 0 & 1 & 0 \end{pmatrix}. \qquad (11)$$

This base code generates five syndrome bits, one for each row of the matrix. Suppose that three additional syndrome bits need to be generated. To do this, the [$N=16$, $k=11,d=4$] extended Hamming code is partitioned into two [$N=8$, $k=4,d=4$] extended Hamming codes with parity check matrices

$$H = \begin{pmatrix} 1 & 1 & 1 & 1 & 1 & 1 & 1 & 1 \\ 1 & 1 & 1 & 1 & 0 & 0 & 0 & 0 \\ 1 & 1 & 0 & 0 & 1 & 1 & 0 & 0 \\ 1 & 0 & 1 & 0 & 1 & 0 & 1 & 0 \end{pmatrix}. \qquad (12)$$

The eight columns of the parity check matrix of the first small extended Hamming codes correspond to the first eight columns of the parity check matrix of the larger extended Hamming code, while the eight columns of the parity check matrix of the second small extended Hamming code correspond to the last eight columns of the parity check matrix of the larger extended Hamming code.

To generate the eight syndrome bits for the two small extended Hamming codes, one need only generate three additional syndrome bits, corresponding to the second, third, and fourth row of the first small extended Hamming code. The syndrome bits corresponding to other rows can be determined as follows. The syndrome bit for the first row of the first small extended Hamming code is equal to the syndrome bit of the second row of the large matrix. The syndrome bit for the first row of the second small extended Hamming code is equal to the modulo-2 sum of the syndrome bit for the first row of the large matrix and the first row of the parity check matrix of the first small parity check matrix. The syndrome bit of the second row of the second small matrix is equal to the modulo-2 sum of the syndrome bits for the second row of the first small parity check matrix and the third row of the large parity check matrix. The other necessary syndrome bits can be determined similarly.

The procedure for partitioning an $N = 16$ extended Hamming code can be used for an extended Hamming code of any size. All such codes can be partitioned into two smaller extended Hamming codes, and the syndrome bits of the new extended Hamming codes can always be transmitted by sending additional syndrome bits and determining the other bits from the bits already sent. In this way, one can avoid wasting the information in the syndrome bits that were previously transmitted. When partitioning extended Hamming codes, we prefer to partition the codes in such a way that the sizes of all the extended Hamming codes in the EHA code are roughly equal.

**The Partition Schedule**

It is important that the base codes in the SCA code are partitioned according to a predetermined schedule that is known at the decoder. For example, if an EHA code is used, a preferred schedule is to always partition into two the first available extended Hamming code that has the largest block-length.

**Overall Structure of the Syndrome Decoder**

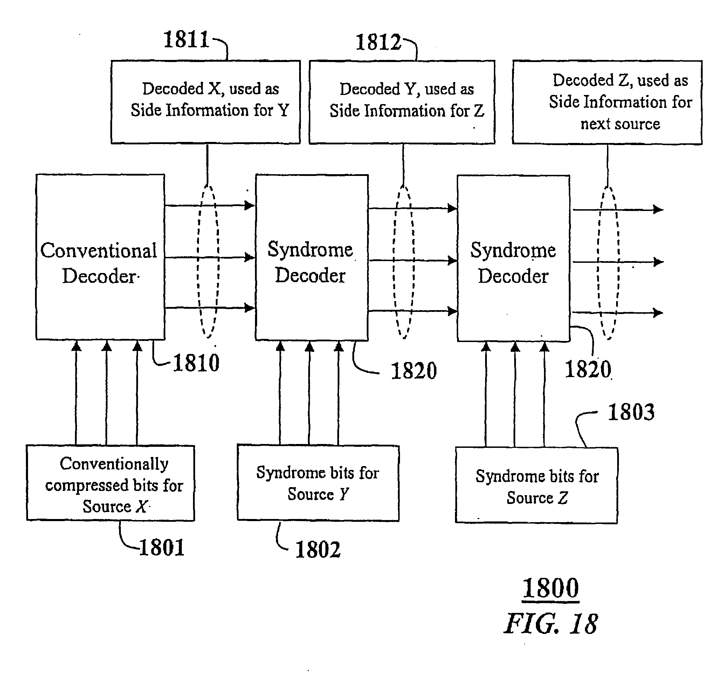

Figure 18 shows a decoder 1800 according to the invention. The decoder essentially performs a decompression of the received syndrome bits to reconstruct the original signals. The decoder includes a conventional decoder 1810, and one or more syndrome decoders 1820. A first signal 1801 is encoded conventionally, and all the remaining signals 1802-1803 are encoded as syndrome bits. In that case, the decoder reconstructs the signal, and uses the reconstructed signal as side information 1811 for the second bitstream. When the second signal 1802 is decoded, the reconstructed signal is used as side information 1812 for the third source, and so on.

**Form of the Probability Distribution for Correlated Sources**

An important input into the syndrome decoder is an estimate of the probability distribution between the correlated signals. We assumed previously that the overall joint probability distribution had a joint Markov structure:

$$p(x_A, x_B, x_C, ...., x_T) = p(x_A)p(x_B \mid x_A)p(x_C \mid x_B)...p(x_T \mid x_S).$$

For each signal $X$ to be decoded using the side information $Y$, it is important to have an estimate of the conditional probability distribution $p(x|y)$.

The conditional probability distribution typically has the form of a Gaussian function or Laplacian distribution that is independently distributed over each integer in the signal. That is, each integer in the signal $X$ is similar to the corresponding integer in the signal $Y$, and the probability that the signals differ by an amount $\Delta$ decreases with some Gaussian or Laplacian distribution in $\Delta$.

Of course, the exact form of the conditional probability distribution depends on the particular application. In some applications, the probability distribution can be estimated by using a set of available correlated signals as a "training" set.

**Multi-Stage Syndrome Decoder**

The syndrome bits for each signal is decoded separately. For each signal, a set of bit-planes is decoded.

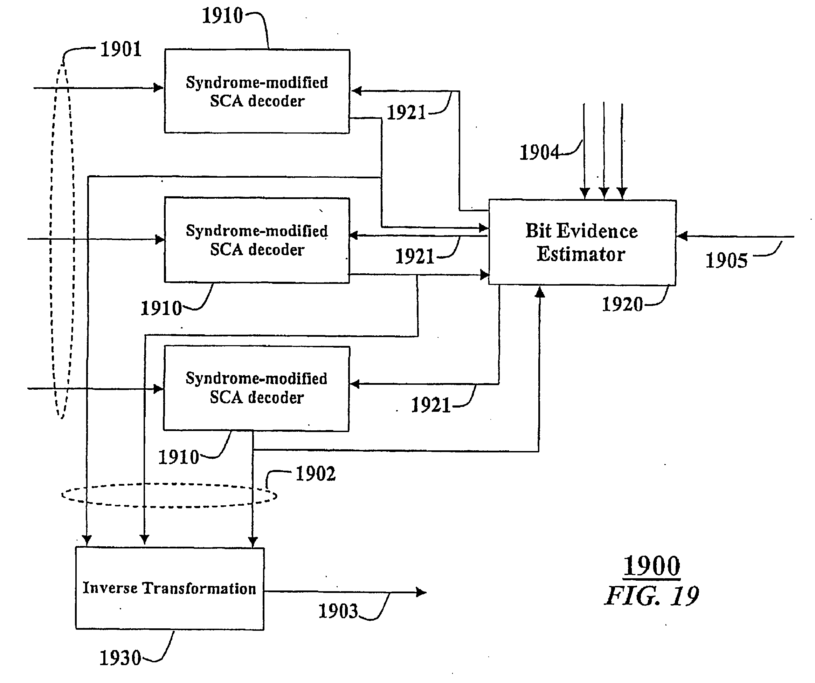

Figure 19 shows the syndrome decoder 1900 according to the invention. The decoder 1900 includes a syndrome-modified serially concatenated accumulate decoder 1910 for each bit plane 1901. The decoder 1900 also includes a bit evidence estimator 1920 for generating bit probability estimates 1921.

We select an order to decode the bit-planes 1901. One reasonable selection is to decode the most significant bits first, and use a resulting coset code-word 1902 to help decode the second most significant bits, and so on until the least significant bits are decoded. Another reasonable selection is to decode in the opposite order, from least significant bits to most significant bits. The resulting coset code-word 1902 is also provided to the estimator 1920.

To decode the first bit-plane, we first determine, for each bit, its *a priori* probability to be a zero or one, using the estimated probability distribution. These probabilities are used as soft-inputs for the decoder of the serially-concatenated accumulate code, modified to decode so that the received syndrome bits are satisfied.

To decode the second bit-plane, we compute for each bit its a priori probabilities using the estimated probability distribution, conditioned on the previously decoded first bit-plane. To decode further bit-planes, we first compute the *a priori* probabilities using the estimated probability distribution, conditioned on all previously decoded bit-planes. Eventually, we will decode all the bit-planes, and the decoding will be complete.

The reconstructed bit-planes are finally sent to an inverse transformation 1930, which undoes the effect of any transformations (e.g. DCT transforms) that were applied at the encoder, and a reconstructed signal 1903 is obtained.

**Bit Evidence Estimator**

The inputs to the bit evidence estimator 1920 are the decoded bit-planes of a previously decoded source 1904, the conditional probability distribution 1905 between a signal $X$ and its side information $Y$, as well as the results of bit planes of $X$ that were previously decoded 1902. The output 1921 is the estimate for the probability that each bit is a zero or one, for the next bit-plane to be decoded. The bit evidence estimator 1920 sums the probability distribution over all integer values that are still possible given the previously decoded bits.

Suppose for example, that the next bit plane to be decoded is the $b^{\text{th}}$ bit-plane, and that the bit evidence estimator is now working on the $i^{\text{th}}$ bit in that bit plane, which we call $x_{bi}$. To determine the probability that $x_{bi}$ is a one, the bit evidence estimator sums the input probability distribution over all integers that are consistent with the previously decoded bit-planes, and such that $x_{bi}$ is a one, divided by the sum of the input probability distribution over all integers that are consistent with the previously decoded bit-planes.

**The Syndrome-Modified Serially-Concatenated Accumulate Decoder**

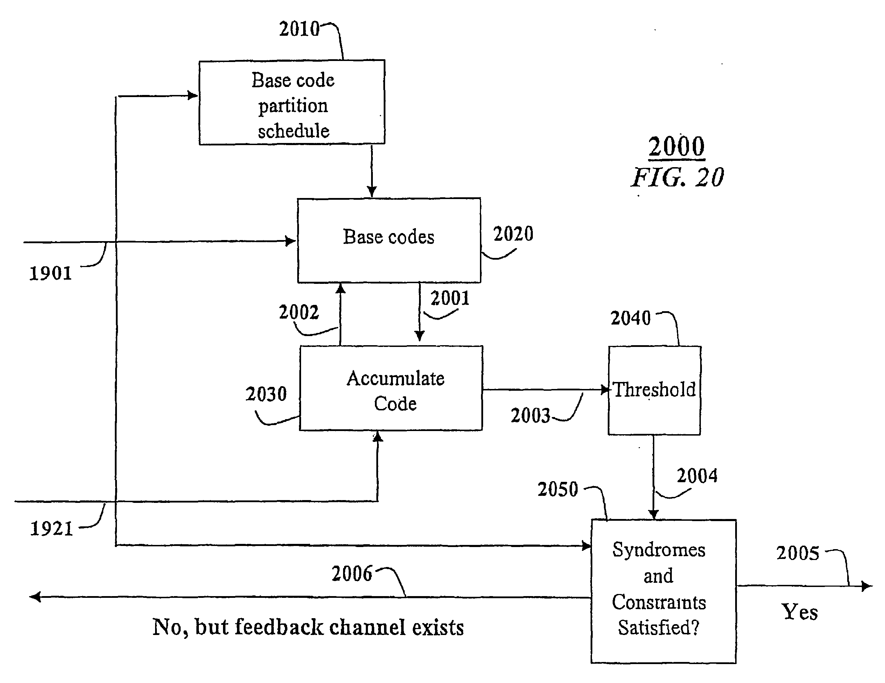

Figure 20 shows a syndrome-modified SCA decoder 2000 according to the invention. The syndrome-modified SCA decoder uses as inputs the probability estimates 1921 for each bit in a bit-plane produced by the bit evidence estimator 1920, and the syndrome bits received 1901.

The syndrome-modified SCA decoder first uses the number of syndrome bits received, and a known base code partitioning schedule 2010, to determine base codes 2020 to be used.

The syndrome-modified SCA decoder can use any of the methods used for SCA codes. The only modification that needs to be made is to the part of the decoder that processes the base codes. That part of the decoder, when it is used as a channel decoder, generates a set of probability estimates for the 'shift' bits, given a set of input probability estimates. The syndrome-modified SCA decoder still does that, but now the decoder is modified to also satisfy a constraint that the received syndromes are also satisfied.

For example, if a syndrome bit is connected to a parity check that is also connected to a number of other shift bits, and if the syndrome bit is equal to zero, the decoder for the base code outputs a set of *a posteriori* probabilities for those other shift bits. To obtain the corresponding set of *a posteriori* probabilities when the syndrome bit is one, one resets the output *a posteriori* probabilities for a shift bit to equal zero to those for the shift bits equaling one, and vice versa.

In the preferred embodiment shown in Figure 20, the syndrome-modified SCA decoder 2000 uses an iterative decoding method, that alternately decodes the accumulate code 2030 and the base codes 2020. The accumulate code, in the preferred embodiment, is decoded using the BCJR method, using the bit probability estimates 1921, and the bit probability estimates for the shift bits from the decoder of the base code 2001. The base code is decoded using the bit probability estimates for the shift bits from the accumulate code 2002, and the received syndrome bits 1901.

In the preferred embodiment, the syndrome-modified SCA decoder alternates between decoding the accumulate code and the base codes for a fixed number of iterations, and then the decoder of the accumulate code produces final bit estimates 2003 for the bits of the bit-plane. These estimates are thresholded 2040, that is, they are converted into hard decisions, to obtain to a final estimate for the bits in the bit-plane 2004.

The final estimate for the bits in the bit-plane is then checked 2050 to see whether the final estimate is a coset code-word, or not i.e., whether the accumulate constraints and the syndrome bits are satisfied. If yes, then the decoding is successful, and the coset code-word 2005 is output as the reconstructed signal. If no, the decoder fails, unless a feedback channel exists, in which case, a request 2006 for more syndrome bits is generated.

### Reconstructing the Original Signal

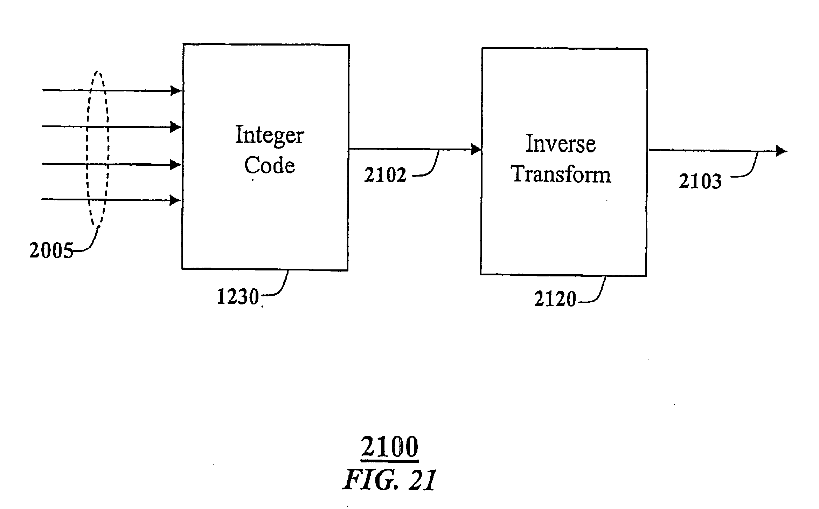

Figure 21 shows an inverse transformation 2100 according to the invention. The original signal 2103 is reconstructed from the coset code-words 2005. The coset code-words 2005 are first converted into a sequence of integers 2102 according to the same integer code 1230 that is used in the encoder 1200. If the integers were obtained by a transform at the encoder, the integers at the decoder are sent through a corresponding inverse transform 2120, to obtain the final reconstructed signal 2103.

### Effect of the Invention

Simulations show that the invention has all the desired requirements for a practical syndrome-based coding. To simulate the system, synthetic correlated signals were generated. The signals include approximately 1000 integers ranging in value from 0 to 255, where each integer in a signal is correlated with the corresponding integers in the neighboring signal by a Gaussian or Laplacian distribution.

The system according to the invention was able to compress such signals using a number of syndrome bits that was just slightly greater (between 2% and 5% overhead, depending on the details of the distributions) than the computed entropy of the system. It was able to achieve this result, while achieving all the other requirements outlined previously.

### Application to Video Compression Systems

The invention described is particularly suited for coding videos in low complexity encoders, as one may find in a cellular telephone, or simple digital camera. The related patent application describes this application in detail. Because our invention enables high compression rates, is incrementally rate-adaptive, and has good performance for low encoding complexity and low decoding complexity, these advantages accrue to the video compression system as well.

### Claims

**1.** A method for compressing a set of correlated signals, comprising the steps of:

> converting each signal to a sequence of integers;
> organizing each sequence of integers as a set of bit-planes;
> the method being **characterized in that** it further comprises the steps of applying, to each bit-plane, an inverse accumulator (1420) determining a modulo-2 sum of neighbouring bits of the bit-plane with modulo-2 summing the first bit of the bit-plane with zero to produce a bit-plane of shifted bits;

permuting each bit-plane of shifted bits according to a predetermined permutation to a produce a bit-plane of permuted bits;

partitioning each bit-plane of permuted bits into a set of blocks of bits; and

generating syndrome bits for each block of bits according to a base code, all the syndrome bits being a compression of the set of correlated signals.

2. The method of claim 1, in which the correlation between the signals is temporal.

3. The method of claim 1, in which the correlation between the signals is spatial.

4. The method of claim 2, in which the correlated signals are images in a video sequence.

5. The method of claim 1, in which the correlated signals are first quantized.

6. The method of claim 1, in which the converting and organizing comprises:

transforming each signal to a set of coefficients; and
quantizing each set of coefficients to produce the set of bit-planes.

7. The method of claim 4, further comprising:

partitioning each image into a set of macroblocks;
transforming each macroblock to a set of coefficients; and
quantizing each set of coefficients to the set of bit-planes.

8. The method of claim 1, in which the base code is a product code.

9. The method of claim 1, in which the base code is an extended Hamming code.

10. The method of claim 1, further comprising:

determining a number of syndromes bits to generate for each correlated signal.

11. The method of claim 10, in which the number of syndrome bits is determined using feedback from a decoder (1800) of the syndrome bits.

12. The method of claim 11, in which the number of syndrome bits is determined using an estimate of a conditional entropy of the correlated signal with respect to available side information.

13. The method of claim 12, in which the side information is a previously reconstructed signal by the decoder (1800).

14. The method of claim 1, in which a number of the syndrome bits that are generated for the corresponding signals varies adaptively according to the level of redundancy in the corresponding signals.

15. The method of claim 14, further comprising:

generating additional syndrome bits incrementally.

16. The method of claim 15, in which the generating of the additional syndrome bits further comprises:

partitioning the base code into a set of reduced length base codes according to a predetermined schedule;
partitioning the corresponding block into a set of reduced length blocks, there being one reduced length code for each reduced length base code; and
generating the additional syndrome bits using the syndromes of the reduced length base codes for the reduced length blocks, and previously generated syndrome bits.

**17.** The method of claim 16, in which the reduced length base codes are extended Hamming codes.

**18.** The method of claim 16, in which the reduced length base codes are products of single parity check codes.

**19.** The method of claim 13, in which a first signal is compressed conventionally.

**20.** The method of claim 1, in which the bit-planes are in a form of Gray codes.

**21.** Method of compression and decompression, whereby the method of compression is performed according to claim 1 and in which decompressing the syndrome bits corresponding to one of the signals further comprises:

generating, for each bit-plane of the corresponding signal, a bit probability estimate for each bit of the bit-plane;
reconstructing the bit-plane using the syndrome bits corresponding to the bit-plane and the bit probability estimates;
reconstructing the sequence of integers corresponding to all of the bit-planes of the corresponding signal; and
reconstructing the signal from the sequence of integers.

**22.** The method of claim 21, in which the bit probability estimate is generated from a probability distribution dependent on a previously reconstructed signal, and conditioned on previously reconstructed bit-planes of the corresponding signal.

**23.** The method of claim 22, in which the probability distribution is a Gaussian function.

**24.** The method of claim 22, in which the probability distribution is a Laplacian function.

**25.** The method of claim 22, further comprising:

estimating the probability distribution from a set of training signals.

**26.** The method of claim 22, in which the previously reconstructed signal is obtained conventionally.

**27.** The method of claim 21, in which the bit-planes are processed, during the decompressing, in order from a most-significant bit to a least-significant bit.

**28.** The method of claim 21, in which the bit-planes are processed, during the decompressing, in order from a least-significant bit to a most-significant bit.

**29.** The method of claim 1, further comprising:

selecting the base codes dependent on the number of syndrome bits to generate and a predetermined base code partitioning schedule.

**30.** The method of claim 21, in which the reconstructing of the bit-plane further comprises:

selecting the base codes dependent on a number of syndrome bits to decompress and a predetermined base code partitioning schedule;
alternately, for a predetermined number of iterations, decoding an accumulate code using the using the bit probability estimates and decoding the selected base codes using the bit probability estimates and the syndrome bits to be decompressed, to produce final bit probability estimates for the bit-plane; and
thresholding the final bit probability estimates to reconstruct the bit-plane.

**31.** The method of claim 30, further comprising:

detennining whether the final thresholded bit probability estimates correspond to a coset codeword;
accepting the final thresholded bit probability estimates as the bit-plane if true; and
rejecting the final thresholded bit probability estimates if false.

**32.** The method of claim 31, in which the rejecting further comprises:

increasing the number of the syndrome bits during the generating of the syndrome bits.

**Patentansprüche**

1. Verfahren zum Komprimieren eines Satzes von korrelierten Signalen, aufweisend die Schritte:

   Umwandeln jedes Signals in eine Folge von ganzen Zahlen;
   Organisieren jeder Folge von ganzen Zahlen als einen Satz von Bitebenen,
   welches Verfahren **dadurch gekennzeichnet ist, dass** es weiterhin die Schritte aufweist:

   Verwenden eines inversen Akkumulators (1420) bei jeder Bitebene, die eine Modulo-2-Summe von benachbarten Bits der Bitebene mit Modulo-2-Summierung des ersten Bits der Bitebene mit null bestimmt, um eine Bitebene von verschobenen Bits zu erzeugen;
   Permutieren jeder Bitebene von verschobenen Bits gemäß einer vorbestimmten Permutation, um eine Bitebene von permutierten Bits zu bilden;
   Teilen jeder Bitebene von permutierten Bits in einen Satz von Blöcken von Bits; und
   Erzeugen von Syndrombits für jeden Block von Bits gemäß einem Basiscode, wobei alle Syndrombits eine Komprimierung des Satzes von korrelierten Signalen sind.

2. Verfahren nach Anspruch 1, bei dem die Korrelation zwischen den Signalen zeitlich ist.

3. Verfahren nach Anspruch 1, bei dem die Korrelation zwischen den Signalen räumlich ist.

4. Verfahren nach Anspruch 2, bei dem die korrelierten Signale Bilder in einer Videosequenz sind.

5. Verfahren nach Anspruch 1, bei dem die korrelierten Signale zuerst quantisiert werden.

6. Verfahren nach Anspruch 1, bei dem das Umwandeln und Organisieren aufweist:

   Transformieren jedes Signals in einen Satz von Koeffizienten; und
   Quantisieren jedes Satzes von Koeffizienten, um den Satz von Bitebenen zu erzeugen.

7. Verfahren nach Anspruch 4, weiterhin aufweisend:

   Teilen jedes Bildes in einen Satz von Makroblöcken;
   Transformieren jedes Makroblocks in einen Satz von Koeffizienten; und
   Quantisieren jedes Satzes von Koeffizienten in den Satz von Bitebenen.

8. Verfahren nach Anspruch 1, bei dem der Basiscode ein Produktcode ist.

9. Verfahren nach Anspruch 1, bei dem der Basiscode ein erweiterter Hamming-Code ist.

10. Verfahren nach Anspruch 1, weiterhin aufweisend:

    Bestimmen einer Anzahl von Syndrombits zur Erzeugung für jedes korrelierte Signal.

11. Verfahren nach Anspruch 10, bei dem die Anzahl von Syndrombits unter Verwendung einer Rückführung von einem Decodierer (1800) der Syndrombits bestimmt wird.

12. Verfahren nach Anspruch 11, bei dem die Anzahl von Syndrombits unter Verwendung einer Schätzung einer konditionellen Entropie des korrelierten Signals mit Bezug auf verfügbare Seiteninformationen bestimmt wird.

13. Verfahren nach Anspruch 12, bei dem die Seiteninformationen ein vorher durch den Decodierer (1800) rekonstruiertes Signal sind.

14. Verfahren nach Anspruch 1, bei dem eine Anzahl der Syndrombits, die für die entsprechenden Signale erzeugt werden, adaptiv gemäß dem Pegel der Redundanz in den entsprechenden Signalen variiert.

**15.** Verfahren nach Anspruch 14, welches weiterhin aufweist:

inkrementelles Erzeugen zusätzlicher Syndrombits.

**16.** Verfahren nach Anspruch 15, bei dem die Erzeugung der zusätzlichen Syndrombits weiterhin aufweist:

Teilen des Basiscodes in einen Satz von Basiscodes reduzierter Länge gemäß einem vorbestimmten Plan;
Teilen des entsprechenden Blocks in einen Satz von Blöcken reduzierter Länge, wobei für jeden Basiscode reduzierter Länge ein Code reduzierter Länge vorhanden ist; und
Erzeugen der zusätzlichen Syndrombits unter Verwendung der Syndrome der Basiscodes reduzierter Länge für die Blöcke reduzierter Länge und vorher erzeugter Syndrombits.

**17.** Verfahren nach Anspruch 16, bei dem die Basiscodes reduzierter Länge erweiterte Hamming-Codes sind.

**18.** Verfahren nach Anspruch 16, bei dem die Basiscodes reduzierter Länge Produkte von Einzelparitäts-Prüfcodes sind.

**19.** Verfahren nach Anspruch 13, bei dem ein erstes Signal herkömmlich komprimiert wird.

**20.** Verfahren nach Anspruch 1, bei dem die Bitebenen in einer Form von Gray-Codes sind.

**21.** Verfahren zur Komprimierung und Dekomprimierung, bei dem das Verfahren zur Komprimierung gemäß Anspruch 1 durchgeführt wird und
bei dem die Dekomprimierung der Syndrombits entsprechend einem der Signale weiterhin aufweist:

Erzeugen für jede Bitebene des entsprechenden Signals einer Bitwahrscheinlichkeitsschätzung für jedes Bit der Bitebene;
Rekonstruieren der Bitebene unter Verwendung der Syndrombits entsprechend der Bitebene und den Bitwahrscheinlichkeitsschätzungen;
Rekonstruieren der Folge von ganzen Zahlen entsprechend allen Bitebenen des entsprechenden Signals; und
Rekonstruieren des Signals aus der Folge von ganzen Zahlen.

**22.** Verfahren nach Anspruch 21, bei dem die Bitwahrscheinlichkeitsschätzung anhand einer Wahrscheinlichkeitsverteilung in Abhängigkeit von einem vorher rekonstruierten Signal erzeugt und auf vorher rekonstruierten Bitebenen des entsprechenden Signals konditioniert wird.

**23.** Verfahren nach Anspruch 22, bei dem die Wahrscheinlichkeitsverteilung eine Gauss'sche Funktion ist.

**24.** Verfahren nach Anspruch 22, bei dem die Wahrscheinlichkeitsverteilung eine Laplace'sche Funktion ist.

**25.** Verfahren nach Anspruch 22, welches weiterhin aufweist:

Schätzen der Wahrscheinlichkeitsverteilung anhand eines Satzes von Trainingssignalen.

**26.** Verfahren nach Anspruch 22, bei dem das vorher rekonstruierte Signal herkömmlich erhalten wird.

**27.** Verfahren nach Anspruch 21, bei dem die Bitebenen während der Dekomprimierung in der Reihenfolge von einem höchstwertigen Bit zu einem niedrigstwertigen Bit verarbeitet werden

**28.** Verfahren nach Anspruch 21, bei dem die Bitebenen während der Dekomprimierung in der Reihenfolge von einem niedrigstwertigen Bit zu einem höchstwertigen Bit verarbeitet werden.

**29.** Verfahren nach Anspruch 1, welches weiterhin aufweist:

Auswählen der Basiscodes in Abhängigkeit von der Anzahl von zu erzeugenden Syndrombits und einem vorbestimmten Basiscode-Teilungsplan.

**30.** Verfahren nach Anspruch 21, bei dem die Rekonstruktion der Bitebene weiterhin aufweist:

Auswählen der Basiscodes in Abhängigkeit von einer Anzahl von zu dekomprimierenden Syndrombits und einem vorbestimmten Basiscode-Teilungsplan;

für eine vorbestimmte Anzahl von Iterationen abwechselndes Decodieren eines Akkumulationscodes unter Verwendung der Bitwahrscheinlichkeitsschätzungen und Decodieren der ausgewählten Basiscodes unter Verwendung der Bitwahrscheinlichkeitsschätzungen und der zu dekomprimierenden Syndrombits, um endgültige Bitwahrscheinlichkeitsschätzungen für die Bitebene zu erzeugen; und

Unterziehen der endgültigen Bitwahrscheinlichkeitsschätzungen einer Schwellenwertbildung, um die Bitebene zu rekonstruieren.

**31.** Verfahren nach Anspruch 30, welches weiterhin aufweist:

Bestimmen, ob die endgültigen, einer Schwellenwertbildung unterzogenen Bitwahrscheinlichkeitsschätzungen einem Nebenklasse-Codewort entsprechen;

Annehmen der endgültigen, einer Schwellenwertbildung unterzogenen Bitwahrscheinlichkeitsschätzungen als die Bitebene, wenn wahr; und

Zurückweisen der endgültigen, einer Schwellenwertbildung unterzogenen Bitwahrscheinlichkeitsschätzungen, wenn falsch.

**32.** Verfahren nach Anspruch 31, bei dem das Zurückweisen weiterhin aufweist:

Erhöhen der Anzahl der Syndrombits während der Erzeugung der Syndrombits.

**Revendications**

**1.** Procédé de compression d'un ensemble de signaux corrélés, comprenant les étapes consistant à :

convertir chaque signal en une séquence de nombres entiers ;

organiser chaque séquence de nombres entiers en un ensemble de plans de bits ;

le procédé étant **caractérisé en ce qu'**il comprend en outre les étapes consistant à :

appliquer à chaque plan de bits un accumulateur inverse (1420) déterminant une somme modulo 2 de bits voisins du plan de bits, en appliquant une somme modulo 2 au premier bit du plan de bits avec zéro afin de produire un plan de bits de bits décalés ;

permuter chaque plan de bits de bits décalés selon une permutation prédéterminée afin de produire un plan de bits de bits permutés ;

partitionner chaque plan de bits de bits permutés en un ensemble de blocs de bits ; et

générer des bits de syndrome pour chaque bloc de bits selon un code de base, tous les bits de syndrome étant une compression de l'ensemble de signaux corrélés.

**2.** Procédé selon la revendication 1, dans lequel la corrélation entre les signaux est temporelle.

**3.** Procédé selon la revendication 1, dans lequel la corrélation entre les signaux est spatiale.

**4.** Procédé selon la revendication 2, dans lequel les signaux corrélés sont des images dans une séquence vidéo.

**5.** Procédé selon la revendication 1, dans lequel les signaux corrélés sont d'abord quantifiés.

**6.** Procédé selon la revendication 1, dans lequel la conversion et l'organisation comprennent les étapes consistant à :

transformer chaque signal en un ensemble de coefficients ; et

quantifier chaque ensemble de coefficients pour produire l'ensemble de plans de bits.

**7.** Procédé selon la revendication 4, comprenant en outre les étapes consistant à :

partitionner chaque image en un ensemble de macroblocs ;

transformer chaque macrobloc en un ensemble de coefficients ; et

quantifier chaque ensemble de coefficients en ensemble de plans de bits.

**8.** Procédé selon la revendication 1, dans lequel le code de base est un code de produit.

**9.** Procédé selon la revendication 1, dans lequel le code de base est un code de Hamming étendu.

**10.** Procédé selon la revendication 1, comprenant en outre l'étape consistant à :

déterminer un nombre de bits de syndrome à générer pour chaque signal corrélé.

**11.** Procédé selon la revendication 10, dans lequel le nombre de bits de syndrome est déterminé en utilisant un retour d'un décodeur (1800) des bits de syndrome.

**12.** Procédé selon la revendication 11, dans lequel le nombre de bits de syndrome est déterminé en utilisant une estimation d'une entropie conditionnelle du signal corrélé en fonction des informations adjacentes disponibles.

**13.** Procédé selon la revendication 12, dans lequel les informations adjacentes correspondent à un signal reconstitué précédemment par le décodeur (1800).

**14.** Procédé selon la revendication 1, dans lequel un nombre des bits de syndrome qui sont générés pour les signaux correspondants varie de façon adaptative selon le niveau de redondance dans les signaux correspondants.

**15.** Procédé selon la revendication 14, comprenant en outre l'étape consistant à :

générer des bits de syndrome supplémentaires de façon incrémentielle.

**16.** Procédé selon la revendication 15, dans lequel la génération des bits de syndromes supplémentaires comprend en outre les étapes consistant à :

partitionner le code de base en un ensemble de codes de base de longueur réduite selon un ordonnancement prédéterminé ;
partitionner le bloc correspondant en un ensemble de blocs de longueur réduite, avec un code de longueur réduite pour chaque code de base de longueur réduite ; et
générer les bits de syndrome supplémentaires en utilisant les syndromes des codes de base de longueur réduite pour les blocs de longueur réduite et les bits de syndrome générés précédemment.

**17.** Procédé selon la revendication 16, dans lequel les codes de base de longueur réduite sont des codes de Hamming étendus.

**18.** Procédé selon la revendication 16, dans lequel les codes de base de longueur réduite sont des produits de codes de contrôle de parité simple.

**19.** Procédé selon la revendication 13, dans lequel un premier signal est compressé de façon conventionnelle.

**20.** Procédé selon la revendication 1, dans lequel les plans de bits se présentent sous la forme de codes de Gray.

**21.** Procédé de compression et de décompression, dans lequel le procédé de compression est effectué selon la revendication 1 et dans lequel la décompression des bits de syndrome correspondant à l'un des signaux comprend en outre les étapes consistant à :

générer, pour chaque plan de bits du signal correspondant, une estimation de probabilité de bit pour chaque bit du plan de bits ;
reconstituer le plan de bits en utilisant les bits de syndrome correspondant au plan de bits et les estimations de probabilité de bit ;
reconstituer la séquence de nombres entiers correspondant à tous les plans de bits du signal correspondant ; et
reconstituer le signal à partir de la séquence de nombres entiers.

**22.** Procédé selon la revendication 21, dans lequel l'estimation de probabilité de bit est générée à partir d'une distribution de probabilité en fonction d'un signal précédemment reconstitué, et préparée sur des plans de bits précédemment reconstitués du signal correspondant.

**23.** Procédé selon la revendication 22, dans lequel la distribution de probabilité est une fonction de Gauss.

**24.** Procédé selon la revendication 22, dans lequel la distribution de probabilité est une fonction de Laplace.

**25.** Procédé selon la revendication 22, comprenant en outre l'étape consistant à :

estimer la distribution de probabilité à partir d'un ensemble de signaux d'apprentissage.

**26.** Procédé selon la revendication 22, dans lequel le signal précédemment reconstitué est obtenu de façon conventionnelle.

**27.** Procédé selon la revendication 21, dans lequel les plans de bits sont traités, pendant la décompression, dans l'ordre à partir d'un bit le plus significatif jusqu'à un bit le moins significatif.

**28.** Procédé selon la revendication 21, dans lequel les plans de bits sont traités, pendant la décompression, dans l'ordre à partir d'un bit le moins significatif jusqu'à un bit le plus significatif.

**29.** Procédé selon la revendication 1, comprenant en outre l'étape consistant à :

sélectionner les codes de base en fonction du nombre de bits de syndrome à générer et d'un ordonnancement prédéterminé de partitionnement de code de base.

**30.** Procédé selon la revendication 21, dans lequel la reconstitution du plan de bits comprend en outre les étapes consistant à :

sélectionner les codes de base en fonction d'un nombre de bits de syndrome à décompresser et d'un ordonnancement prédéterminé de partitionnement de code de base ;
en variante, pour un nombre prédéterminé d'itérations, décoder un code d'accumulation en utilisant les estimations de probabilité de bit et décoder les codes de base sélectionnés en utilisant les estimations de probabilité de bit et les bits de syndrome à décompresser, pour produire des estimations de probabilité de bit finales pour le plan de bits ; et
appliquer des seuils aux estimations de probabilité de bit finales pour reconstituer le plan de bits.

**31.** Procédé selon la revendication 30, comprenant en outre les étapes consistant à:

déterminer si les estimations de probabilité de bit seuillées finales correspondent à un mot de code coset ;
accepter les estimations de probabilité de bit seuillées finales en tant que plan de bits si elles sont vraies ; et
rejeter les estimations de probabilité de bit seuillées finales si elles sont fausses.

**32.** Procédé selon la revendication 31, dans lequel le rejet comprend en outre l'étape consistant à :

augmenter le nombre des bits de syndrome pendant la génération des bits de syndrome.

EP 1 668 780 B1

**100**

*FIG. 1*

$$\underline{200}$$
*FIG. 2*

$$\underline{300}$$

*FIG. 3*

EP 1 668 780 B1

FIG. 4

$H(Y)$

$H(X|Y)$

Reconstruction
possible

411

$H(Y|X)$

Reconstruction
impossible

412

401

$H(X)$

EP 1 668 780 B1

**500**

*FIG. 5*

$$\underline{600}$$
*FIG. 6*

700
FIG. 7

$$\underline{800}$$

*FIG. 8*

*FIG. 9*

1000
FIG. 10

1100
*FIG. 11.*

EP 1 668 780 B1

1200

*FIG. 12*

1300

*FIG. 13*

**1400**

*FIG. 14*

1501
1510
Extended Hamming Code
Extended Hamming Code
Extended Hamming Code
1520
Permutation
1503
1504
1505

1500

*FIG. 15*

1600
FIG. 16

**FIG. 17**

Decoded X, used as Side Information for Y

1811

Decoded Y, used as Side Information for Z

1812

Decoded Z, used as Side Information for next source

Conventional Decoder

1810

Syndrome Decoder

1820

Syndrome Decoder

1820

Conventionally compressed bits for Source X

1801

Syndrome bits for Source Y

1802

Syndrome bits for Source Z

1803

1800

FIG. 18

*1900*
*FIG. 19*

2000
FIG. 20

EP 1 668 780 B1

2005

Integer
Code

1230

2102

Inverse
Transform

2120

2103

2100
FIG. 21

**EP 1 668 780 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **D. SLEPIAN ; J.K. WOLF.** Noiseless Coding of Correlated Information Sources. *IEEE Transactions on Information Theory,* 1973, vol. 19, 471-480
- **A.D. WYNER.** Recent Results in the Shannon Theory. *IEEE Transactions on Information Theory,* 1974, vol. 20, 2-10
- **S. VERDU.** Fifty years of Shannon Theory. *IEEE Transactions on Information Theory,* 1998, vol. 44, 2057-2078
- **A.D. WYNER ; J. ZIV.** The rate-distortion function for source coding with side information at the decoder. *IEEE Transactions on Information Theory,* 1976, vol. 22, 1-10
- **C.E. SHANNON.** A Mathematical Theory of Communication. *Bell Sys. Tech. Journal,* 1948, vol. 27, 379-423
- **T.M. COVER ; J.A. THOMAS.** Elements of Information Theory. 1990
- **S. LIN ; D.J. COSTELLO, JR.** Error Control Coding, 2nd Edition. Pearson Prentice Hall, 2004
- **C.E. SHANNON.** A Mathematical Theory of Communication. *Bell Syst. Tech. Journal,* 1948, vol. 27, 379-423 623656
- **S.-Y. CHUNG ; G. FORNEY ; T. RICHARDSON ; R. URBANKE.** On the Design of Low-Density Parity-Check Codes Within .0045 dB of the Shannon Limit. *IEEE Communications Letters,* February 2001, vol. 5, 58-60
- **F.R. KSCHISCHANG ; B.J. FREY ; H.-A. LOELIGER.** Factor Graphs and the Sum-Product Algorithm. *IEEE Transactions on Information Theory,* February 2001, vol. 47, 498-519
- **G.D. FORNEY, JR.** Codes on Graphs: Normal Realizations. *IEEE Transactions on Information Theory,* February 2001, vol. 47, 520-549
- **R.M. TANNER.** A Recursive Approach to Low-Complexity Codes. *IEEE Transactions on Information Theory,* September 1981, vol. 27, 533-547
- **D. DIVSALAR ; H. JIN ; R. J. MCELIECE.** Coding Theorems for 'turbo-like' codes. *Proceedings of the 36th Allerton Conference on Communication, Control, and Computing,* September 1998, 201-210
- **L.R. BAHL ; J. COCKE ; F. JELINEK ; J. RAVIV.** Optimal Decoding of Linear Codes for Minimizing Symbol Error Rate. *IEEE Transactions on Information Theory,* 1974, vol. 20, 284-287
- **J. LI ; K.R. NARAYANAN ; C.N. GEORGHIADES.** Product Accumulate Codes: A Class of Codes With Near-Capacity Performance and Low Decoding Complexity. *IEEE Transactions on Information Theory,* January 2004, vol. 50, 31-46
- **M. ISAKA ; M. FOSSORIER.** High Rate Serially Concatenated Coding with Extended Hamming Codes. *IEEE Communications Letters,* 2004
- **D. DIVSALAR ; S. DOLINAR.** Concatenation of Hamming Codes and Accumulator Codes with High Order Modulation for High Speed Decoding. *IPN Progress Report 42-156, Jet Propulsion Laboratory,* 15 February 2004
- **H. IMAI ; S. HIRIKAWA.** A New Multilevel Coding Method Using Error-Correcting Codes. *IEEE Transactions in Information Theory,* May 1977, vol. 23, 371-376
- **S.S. PRADHAN ; K. RAMCHANDRAN.** Distributed Source Coding Using Syndromes (DISCUS): Design and Construction. *IEEE Transactions on Information Theory,* March 2003, vol. 49, 626-643
- **A. LIVERIS ; Z. XIONG ; C. GEORGHIADES.** Compression of binary sources with side information at the decoder using LDPC codes. *IEEE Communications Letters,* October 2002, vol. 6, 440-442
- **SEHGAL A.** A state-free causal video encoding paradigm. *Proceedings 2003 International Conference on Image Processing,* vol. 2 of 3, 605-608